(19) Europäisches Patentamt
European Patent Office
Office européen des brevets

(11) **EP 4 372 812 A1**

(12) **EUROPEAN PATENT APPLICATION**

(43) Date of publication:
**22.05.2024   Bulletin 2024/21**

(21) Application number: **22207786.9**

(22) Date of filing: **16.11.2022**

(51) International Patent Classification (IPC):
**H01L 23/498** (2006.01)

(52) Cooperative Patent Classification (CPC):
**H01L 23/49838;** H01L 21/4857; H01L 23/49816;
H01L 23/49822; H01L 23/49827

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **AT & S Austria Technologie & Systemtechnik Aktiengesellschaft 8700 Leoben-Hinterberg (AT)**

(72) Inventor: **Oggioni, Stefano Sergio 8700 Leoben (AT)**

(74) Representative: **Dilg, Haeusler, Schindelmann Patentanwaltsgesellschaft mbH Leonrodstraße 58 80636 München (DE)**

(54) **DEFINING DISTRIBUTION OF WIRING ELEMENTS COMPLIANT WITH TARGET CURRENT-RELATED VALUE IN COMPONENT CARRIER WITH ROWS OF EQUIDISTANT WIRING ELEMENTS**

(57)   A method of defining a distribution of wiring elements (108) in accordance with at least one target current-related value concerning an electric current to be transmitted over at least a portion of a region between a first main surface and a second main surface of a component carrier (100), wherein the component carrier (100) comprises a stack (102) comprising at least one electrically conductive layer structure (104) and at least one electrically insulating layer structure (106), wherein the at least one electrically insulating layer structure (106) comprises a plurality of wiring elements (108) arranged in a wiring plane (162) to form a first row (110) of equidistant wiring elements (108) arranged along a straight direction within the wiring plane (162) and a second row (112) of equidistant wiring elements (108) arranged along the straight direction within the wiring plane (162), the method comprising defining structural and electrical features of the wiring elements (108), defining distribution features indicative of a distribution of the wiring elements (108), defining amounts of the distributed wiring elements (108) to be provided in a respective area of the wiring plane (162), and defining the distribution of the wiring elements (108) in accordance with requirements of the at least one target current-related value in dependence of the defined structural and electrical features of the wiring elements (108), the defined distribution features, and the defined amounts of the distributed wiring elements (108).

Fig. 8

EP 4 372 812 A1

Fig. 9

## Description

The invention relates to a component carrier, and to a method of defining a distribution of wiring elements in accordance with at least one target current-related value.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

Designing component carriers for achieving compliance with one or more target requirements, for instance defined by a specification, may be difficult, in particular when surface mounting at least one powerful electronic component on the component carrier.

It is an object of the invention to enable manufacture of component carriers for achieving compliance with one or more target requirements.

In order to achieve the object defined above, a component carrier, and a method of defining a distribution of wiring elements in accordance with at least one target current-related value according to the independent claims are provided.

According to an exemplary embodiment of the invention, a method of defining a distribution of wiring elements in accordance with at least one target current-related value concerning an electric current to be transmitted over at least a portion of a region between a first main surface and a second main surface of a component carrier is provided, wherein the component carrier comprises a stack comprising at least one electrically conductive layer structure and at least one electrically insulating layer structure, wherein the at least one electrically insulating layer structure comprises a plurality of wiring elements arranged in a wiring plane to form a first row of equidistant wiring elements arranged along a straight direction within the wiring plane and a second row of equidistant wiring elements arranged along the straight direction within the wiring plane, the method comprising defining structural and electrical features of the wiring elements, defining distribution features indicative of a distribution of the wiring elements, defining amounts of the distributed wiring elements to be provided in a respective area of the wiring plane, and defining the distribution of the wiring elements in accordance with requirements of the at least one target current-related value in dependence of the defined structural and electrical features of the wiring elements, the defined distribution features, and the defined amounts of the distributed wiring elements.

According to another exemplary embodiment of the invention, a component carrier is provided which comprises a stack comprising at least one electrically conductive layer structure and at least one electrically insulating layer structure, and a plurality of wiring elements on the at least one electrically insulating layer structure which are arranged in a wiring plane to form a first row of equidistant wiring elements arranged along a straight direction within the wiring plane and a second row of equidistant wiring elements arranged along the straight direction within the wiring plane, wherein said wiring elements are distributed within the wiring plane to comply with a target current-related value concerning an electric current to be transmitted over at least a portion of a region between a first main surface and a second main surface of the component carrier, said at least one target current-related value corresponding to a ratio between an area value occupied by electrically conductive material of the wiring elements within a unit area and an area value of the unit area of the stack, from a frontal view, in a range from 6% to 11%.

According to still another exemplary embodiment of the invention, a program element (for instance a software routine, in source code or in executable code) is provided, which, when being executed by a processor (such as a microprocessor or a CPU), is adapted to control or carry out a method having the above mentioned features.

According to yet another exemplary embodiment of the invention, a computer-readable medium (for instance a CD, a DVD, a USB stick, an SD card, a floppy disk or a hard disk, or any other (in particular also smaller) storage medium) is provided, in which a computer program is stored which, when being executed by a processor (such as a microprocessor or a CPU), is adapted to control or carry out a method having the above mentioned features.

Data processing which may be performed according to embodiments of the invention can be realized by a computer program, that is by software, or by using one or more special electronic optimization circuits, that is in hardware, or in hybrid form, that is by means of software components and hardware components.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "stack" may particularly denote a sequence of two or more layer structures formed on top of each other. For instance, layer structures of a layer stack may be connected by lamination, i.e. the application of heat and/or pressure. Preferably, the stacked layer structures may be arranged parallel to each other.

In the context of the present application, the term "layer structure" may particularly denote a continuous layer, a patterned layer, or a plurality of nonconsecutive islands within a common plane.

In the context of the present application, the term "wiring elements" may particularly denote electrically conductive elements forming part of a wiring or electric interconnection within a dielectric matrix of the stack. Wiring elements may be formed within an electrically insulating layer structure and as part of an electrically conductive layer structure. The wiring elements may comprise vertical through-connections for creating vertical electrical interconnections between different layer structures of the stack. The wiring elements may comprise electrically conductive through-connections extending through the thickness of the layer structure(s) and/or stack, preferably from one main surface to the opposed main surface of said layer structure(s) and/or stack, and/or along a perpendicular or inclined direction with respect to one of the main surfaces of said layer structure(s) and/or stack. Such connections may be vias, such as metallic laser vias, metallic mechanically drilled vias, sleeve shaped vias, full metal vias, metallic posts, or the like. Wiring elements may also comprise horizontal electrically conductive structures, such as traces and/or pads. Moreover, wiring elements may have straight and/or tapered shapes, e.g. cylindrical or frustoconical shapes.

In the context of the present application, the term "row of equidistant wiring elements" may denote a group of wiring elements arranged along a straight direction and having a constant mutual spacing between each pair of adjacent wiring elements of said row. In other words, the mutual spacing may be the same for each two neighboured wiring elements belonging to the group. For example, only the equidistant wiring elements of the row may be arranged along said straight direction. Alternatively, it is also possible that one or more further wiring elements are arranged between the equidistant wiring elements of the row along said straight direction. For example, a row of equidistant wiring elements may be a sequence of at least three, in particular of at least ten, wiring elements with the same mutual distance with respect to its neighbouring wiring element or elements of the group. A person skilled in the art will understand that, when forming equidistant wiring elements, technical tolerances (in particular manufacturing tolerances) may occur inevitably, which may lead to a very small deviation of an exactly identical distance between adjacent wiring elements of the row. However, when designing a component carrier for subsequent manufacture, equidistant wiring elements can be defined (for example in a design file) to have the same mutual target distance from each other. For example, actually manufactured equidistant wiring elements may have a mutual spacing or distance from each other which may deviate from an identical target distance by not more than a wiring element diameter. For example, actually manufactured equidistant wiring elements may have a mutual spacing or distance from each other which may deviate from an identical target distance by less than 5%, in particular by less than 2%. Due to technical tolerances, also dimensions (such as diameters) of equidistant wiring elements may show unavoidable variations, although - in an embodiment - equidistant wiring elements can be constructed (for example in a design file) to have the same dimensions (such as diameters). The length between two mutual wiring elements may be measured by measuring the distance between the centre of a first wiring element and the centre of a second wiring element (in nearest proximity along said straight direction).

In the context of the present application, the term "distribution of wiring elements" may particularly denote a spatial arrangement of wiring elements in a stack of a component carrier. In particular, this term may denote a spatial arrangement of said wiring elements in one or more horizontal wiring planes of said stack. Preferably, the longest elongation direction of said wiring elements are arranged parallel to the stack thickness direction.

In the context of the present application, the term "target current-related value" may particularly denote at least one parameter value which relates to an electric current which is intended to flow through at least part of the wiring elements during operation of the component carrier. For example, the target current-related value may be an ampacity or a current carrying capacity of at least part of the wiring elements of the component carrier. Ampacity may be a maximum current, in amperes, that a conductor can carry continuously under conditions of use without exceeding its temperature rating. Ampacity may also be denoted as current-carrying capacity. The ampacity of a conductor may depend on its ability to dissipate heat without damage to the conductor or its insulation. This may be a function of the insulation temperature rating, the electrical resistance of the conductor material, the ambient temperature, and/or the ability of the insulated conductor to dissipate heat to the surrounding. Electrical conductors may have some resistance to the flow of electricity. Electric current flowing through them may cause voltage drop and power dissipation, which heats conductors. Copper or aluminum can conduct a large amount of current without damage, but long before conductor damage, insulation may be damaged by the resultant heat. Also, the target current-related value may be an admissible current density. The target current-related value may also be a target value of an electric current which may flow through the component carrier per cross-sectional area in a horizontal wiring plane.

In the context of the present application, the term "structural and electrical features of wiring elements" may particularly denote attributes of the wiring elements being related to the geometrical properties (such as dimensions, shape and/or outline) and the electrical behaviour (for example an electrically conductive material forming a respective wiring element, electric conductivity, electrical resistivity) of the wiring elements.

In the context of the present application, the term "distribution features indicative of distribution of wiring elements" may particularly denote information indicating how the different wiring elements are arranged relatively to each other in the stack or in a wiring plane. In particular, the distribution features may define a spatial pattern according to which the wiring elements are positioned within a horizontal wiring plane and/or three-dimensionally in the stack. For instance, the distribution features may characterize Voronoi cells having a center and/or corners on which wiring elements are placed.

In the context of the present application, the term "amounts of distributed wiring elements in an area of a wiring plane" may particularly denote information including a number of wiring elements in a spatial portion of or in the entire wiring plane. Said amounts may also indicate a metallic area of the wiring elements in a spatial portion of or in the entire wiring plane. For instance, the amounts of distributed wiring elements may indicate a sum of the partial metal areas of all wiring elements of a wiring plane or of a plurality of wiring planes of a stack.

In the context of the present application, the term "wiring plane" may particularly denote a common plane on that the rows (i.e the first and the second rows) of the wiring elements are provided. The common plane may be defined from a planar view perpendicular to one main surface of a layer structure and/or stack. The common plane may be defined as a plane parallel to a main surface of a layer structure and/or stack, preferably the common plane corresponds to a main surface of a layer structure and/or stack.

In the context of the present application, the term "ratio between an area value occupied by electrically conductive material of wiring elements within a unit area and an area value of the unit area of the stack from a frontal view" may particularly denote a percentage of a unit area in a wiring plane occupied by metal of the wiring elements. For example, the mentioned unit area may be a reference area value (for example 1 $mm^2$), a full wiring plane area or an area of a functional portion thereof (for instance a portion of a wiring plane fulfilling a dedicated electric function such as electric power supply). The frontal view may be a view onto the wiring plane or onto the stack from an upper main surface thereof, i.e. from a main surface on which an electronic component is to be surface mounted on the stack. To give an example, the component carrier may be defined by two extremity values of the area occupied by wiring elements (such as plated holes) with respect to the unit area of the carrier (for instance 1 $mm^2$). The lower extremity value may be about 6% (for instance corresponding to a number of 4 holes each with a diameter of 350 $\mu$m and a plating thick-

ness of 15 $\mu$m, corresponding to about 0.063 $mm^2$) and about 11% (for instance 7 holes with diameter 225 $\mu$m, plating thickness 25 $\mu$m, corresponding to 0.11 $mm^2$). This ratio may be understood in accordance with a scenario where the lands have a dimension greater than the dimension of the respective hole, for example a diameter of 500 $\mu$m for the lands associated to the holes with a diameter of 350 $\mu$m and a diameter of 375 $\mu$m for the lands associated to the holes with a diameter of 225 $\mu$m, said lands being spaced from each other by 50$\mu$m. As an alternative embodiment, the lands may have the same frontal dimension as the vias and these vias can be spaced from each other by 50 $\mu$m. In that case, the range may be between 5% (for instance 4 holes with diameter 300 $\mu$m, plating thickness 15 $\mu$m, corresponding to about 0.054 $mm^2$) and 15% (for instance 9 holes with diameter 250 $\mu$m, plating thickness 25 $\mu$m, corresponding to about 0.16 $mm^2$).

In the context of the present application, the term "main surface" of a body may particularly denote one of two largest opposing surfaces of the body. The main surfaces may be connected by circumferential side walls. The thickness of a body, such as a stack or a component carrier, may be defined by the distance between the two opposing main surfaces.

According to an exemplary embodiment, a distribution of wiring elements may be defined for a layer stack-type component carrier to be designed and subsequently manufactured for achieving compliance with one or more target current-related values relating to an electric current which shall flow through the component carrier during operation. In order to achieve this goal, wiring elements may be arranged in a wiring plane to form rows of equidistant wiring elements arranged along a straight direction. On this basis, an algorithm for defining the wiring elements' distribution may be executed which takes into consideration at least structural and electrical features of the wiring elements, distribution features indicative of a distribution of the wiring elements, and amounts of the distributed wiring elements to be provided in a respective area of the wiring plane. A correspondingly obtained design of the wiring elements' distribution may allow to construct a component carrier in compliance with target current requirements, which may be defined in a specification. The mentioned meaningful criteria considered for the definition of the wiring elements' distribution may ensure compliance with necessary conditions while leaving sufficient degrees of freedom for adjusting (for instance fitting) properties for guaranteeing a proper current behavior of the component carrier during operation. Advantageously, the explained adjustment of one or more target current-related values may correspond to a ratio between an area value occupied by electrically conductive material of the wiring elements within a unit area and an area value of the unit area of the stack, from a frontal view, in a range from 6% to 11%. This range has turned out as an excellent compromise between a sufficiently high metal density for ensuring a high current carrying capacity and a sufficiently large distance between adjacent wiring elements for reliably preventing electrical breakdown and disruptive discharge.

In the following, further exemplary embodiments of the component carrier and the method will be explained.

In an embodiment, defining the distribution features comprises arranging the wiring elements of the second row with an offset along the straight direction with respect to the wiring elements of the first row. In the context of the present application, the term "offset rows of wiring elements" may particularly denote rows of wiring elements being arranged with a spatial shift between, on the one hand, the equidistant wiring elements of the first row and, on the other hand, the equidistant wiring elements of the second row along a straight direction along which also the wiring elements of the first row and of the second row are arranged. More specifically, the equidistant wiring elements of the second row may be displaced as a whole along the straight direction with regard to the equidistant wiring elements of the first row. Due to said non-zero offset, the wiring elements of the first row may be out of alignment with respect to the wiring elements of the second row what concerns said straight direction. Apart from this, the wiring elements of the first row and the wiring elements of the second row may or may not be spaced or offset from each other along a further direction perpendicular to said straight direction. Both said directions (i.e. the straight direction and the further direction) may be within a common wiring plane. Arranging the rows of wiring elements with mutual offset may promote compliance with the one or more target current-related values to be achieved without the risk of a disruptive discharge between adjacent wiring elements.

In an alternative embodiment, it may be possible to define the distribution features by arranging the wiring elements of the second row without an offset along the straight direction with respect to the wiring elements of the first row.

In an embodiment, defining the distribution features comprises arranging at least part of the wiring elements at centers of hexagonal virtual cells of the wiring plane, each of said hexagonal virtual cells being adjacent one to the other sharing a respective side of a respective hexagon with a respective adjacent hexagon. Hence, a plane of wiring elements of a component carrier may be configured in accordance with Voronoi cells with hexagonal outline. A wiring plane or a region of interest thereof may thus be virtually divided into a plurality of hexagonal virtual cells which may be connected directly with each other along respective sides. For instance, the wiring elements may be arranged in centres of such hexagonal virtual cells, and/or at corners thereof. Such a regular pattern of virtual hexagonal virtual cells may translate into a wiring pattern of high symmetry which may lead to a well-defined electric distribution system. Hence, no free space and no gaps may remain between the adjacent hexagonal virtual cells. As an alternative to hexagonal virtual cells, other embodiments may also implement cells with another outline, for instance regular triangular cells or rectangular (preferably square) cells. Subdividing a wiring plane into Voronoi cells has turned out as a powerful tool for achieving compliance with current-related values while simultaneously ensuring electric safety.

In an embodiment, defining the distribution features comprises arranging the wiring elements so that a mutual distance between adjacent equidistant wiring elements of the first row equals to a mutual distance between adjacent equidistant wiring elements of the second row. In other words, a spacing of adjacent ones of the equidistant wiring elements of the first row may be the same as a mutual spacing between adjacent ones of the equidistant wiring elements of the second row. This may provide a high degree of symmetry and may therefore promote a high current carrying capacity in combination with high electric reliability.

In an embodiment, the method comprises providing a plurality of further wiring elements in a further electrically insulating layer structure of the stack, and arranging the plurality of further wiring elements in a further wiring plane parallel to the wiring plane and in accordance with a corresponding pattern as but another density of wiring elements than the first row and the second row of wiring elements. For instance, the arrangement of the wiring elements described above may relate to a core with metalized through-holes (i.e. metal filed mechanically/laser drilled through-holes or plated mechanical/laser drilled through-holes), whereas the further wiring elements according to the presently described embodiment may relate to a build-up layer on top or bottom of such a core and may comprise metalized laser vias (or vice versa). For example, a wiring plane with wiring elements comprising metalized laser vias may have smaller dimensioned wiring elements and a higher number of wiring elements per area or volume than a core having larger metallized through-holes with a smaller number of wiring elements per area or volume. While the density of wiring elements may be different for said different wiring planes, the regularity of the pattern of wiring elements in such different wiring planes may be correspondingly. It is possible that the wiring elements and the further wiring elements are electrically coupled with each other, partially or entirely. For example, a plurality of further wiring elements (for instance metalized laser vias) may be electrically coupled with one wiring element (for example a metalized through hole) by connecting said further wiring elements to an annular land around said wiring element.

In an embodiment, the method comprises arranging the wiring elements in a shadow area of a component being surface mounted on the stack of the component carrier. Correspondingly, the component carrier may comprise a component being surface mounted on the stack. The above-mentioned wiring elements may be arranged, partially or entirely, in a shadow area of the surface mounted component. A shadow area of a surface mounted component may correspond to a spatial region in the stack in which electric connections for the component shall be arranged. For instance, the shadow area may taper from an interior of the stack towards the surface mounted component. Such a tapering may reflect the fact that a density of wiring elements can be larger closer to the surface mounted component compared to a stack portion further remote from the surface mounted component. Such a tapering may correspond to a redistribution function of the wiring elements.

A shadow area of the above-mentioned surface mounted component may be a projection of the surface mounted component onto wiring planes of the stack in which the wiring elements are arranged. In particular, the region directly below the component may be most critical in terms of an electric interconnection. For this purpose, specifically said shadow area beneath a surface mounted component (for instance having a very high number of I/O pads) may be advantageous. The shadow area may extend into the stack vertically, or in such a way that it tapers towards the surface mounted component. The latter measure may reflect a redistribution structure arrangement beneath the surface mounted component so as to achieve compliance with a larger pitch of a mounting base beneath the stack (for example a mounting base embodied as printed circuit board).

Hence, the component carrier may comprise at least one surface mounted component, such as a semiconductor chip, in particular a power semiconductor chip or a processor chip. It is also possible that a plurality of electronic components are surface mounted on the stack. Additionally or alternatively, one or more electronic components may be embedded in the stack, and may also be served by the wiring elements concerning their electric interconnection.

In an embodiment, the method comprises arranging the at least one electrically insulating layer structure comprising the wiring elements in a core of the component carrier. Thus, a component carrier may have a stack with a central core of fully cured dielectric material having a high thickness (for example with a thickness in the range between 200 $\mu$m and 2 mm) and having metalized through holes extending therethrough. For example, a core may have a thickness in a range from 500 $\mu$m to 2 mm. A build-up may be formed on one or both of opposing main surfaces of such a core and may have a higher density of wiring elements, which may be embodied as metal filled laser vias. The core may have a key function in terms of distribution of power and signals and may therefore be designed in accordance with the equidistant wiring element rows, as described above.

In an embodiment, the at least one target current-related value comprises a minimum requirement relating to a target current carrying capability or capacity, in particular a current density of 0.5 A/mm$^2$ to 15 A/mm$^2$. Correspondingly, the at least one target current-related value of the component carrier may be a current density of 0.5 A/mm$^2$ to 15 A/mm$^2$. If such a current density, or current carrying capacity per area, is achieved, the component carrier meets even demanding requirements of high-performance computing (HPC) applications.

In an embodiment, the structural and electrical features comprise at least one of a hole diameter (such as drill diameter) of the wiring elements, a cross sectional area of the wiring elements, at least one wall plating-related parameter of the wiring elements, at least one operation temperature-related property of the wiring elements, a dimension of a conductive area directly connected with the wiring elements (in particular a land diameter of the wiring elements), a current carrying capability of the wiring elements, and a resistivity of the wiring elements. When defining at least part of the aforementioned structural and/or electrical features of the wiring elements, boundary conditions may be defined which may promote compliance with the one or more target current-related electric current values. At the same time, said definition may still leave a sufficiently high number of design parameters variable which can be adjusted or modified for designing the component carrier in accordance with the at least one target current-related value.

In an embodiment, the distribution features are indicative of a pattern, in particular of a regular pattern and/or of a Voronoi pattern, in accordance with which the wiring elements are to be arranged. A regular pattern may be defined for example through the provision of the first and the second rows (aligned or offset one to each other along the straight direction) spaced one to each other along the direction perpendicular with respect to the straight direction. Additionally or alternatively, the first row and the second row can be provided on the same straight line, whereas a third row can be spaced from the first and the second row along the direction perpendicular with respect to the straight direction, eventually offset with respect to the first and/or the second row. Preferably, the first, the second (and eventually the third) rows can be repeatedly provided several times, preferably along the direction perpendicular with respect to the straight direction. In a preferred embodiment, the wiring elements may be arranged in accordance with Voronoi cells within the wiring plane. In mathematics, a Voronoi cell may denote a region or partition of a plane (presently a wiring plane) including all points of the plane closer to a specific object (in this case a mechanically drilled through hole) than to any other object in the plane. A set of Voronoi cells defines a Voronoi diagram. Voronoi cells may provide an excellent basis for determining an arrangement of wiring elements of a wiring plane of a stack. They have a high degree of symmetry and may be free of gaps in between. The high symmetry of a corresponding arrangement of wiring elements may translate into well-defined and highly appropriate electric properties.

In an embodiment, the Voronoi cells are hexagonal virtual cells, in particular each delimited by a regular hexagon. However, the Voronoi cells may also be triangular cells, rectangular cells, or other polygonal Voronoi cells.

In an embodiment, the distribution features comprise at least one of at least one equidistance parameter (in particular depending on a hole or drill diameter and/or a land diameter of the wiring elements), an offset value indicating an offset between the wiring elements of the first row and of the second row with respect to each other, and at least one parameter indicating an overlap of wiring elements of different areas. For example, the equidistance parameter may define a mutual spacing between adjacent wiring elements of a respective row. Such a spacing may be selected in accordance with at least one diameter parameter characterizing the respective wiring elements. For instance, a spacing may be larger for larger wiring elements. Even an offset value being indicative of an offset between rows of wiring comments may be selected larger when larger wiring elements are involved, in particular for avoiding electrostatic discharge phenomena. Furthermore, overlap between different wiring elements in different areas (for instance in different wiring planes) may be limited, for instance to avoid an undesired interaction or to suppress crosstalk.

In an embodiment, the method comprises defining the amounts of the distributed wiring elements depending on the structural and electrical features and/or depending on the distribution features. Advantageously, an interaction between the different parameters used as a basis for defining the distribution of wiring elements may be taken into account. Thus, number and/or metal area of wiring elements may be selected depending on the electrical and mechanical attributes as well as the distribution scheme of the wiring elements. This may allow to achieve even better results in terms of compliance with the one or more target current-related values of the electric current to be transmitted within the component carrier.

In an embodiment, the method comprises defining the distribution of the wiring elements in accordance with said requirements by a processor. Thus, the determination of the component carrier design based on the above mentioned input definitions (i.e. said definition of structural and electrical features, said definition of distribution features, and said definition of amounts of the distributed wiring elements) may be carried out by a processor which may execute a corresponding software code. For instance, such a processor may modify remaining degrees of freedom for component carrier design while ensuring that the defined structural and electrical features, the distribution features and the amount of distributed wiring elements per area are taken into account in the derived component carrier design. A further mandatory confinement of a computer fit executed by the processor may be that the at least one target current-related value can be obtained with the designed component carrier.

In an embodiment, the method comprises defining the distribution by the processor executing a fitting algorithm fitting one or more variable design parameters different from the defined requirements. For instance, such a fitting may be adjusted for achieving compliance of a component carrier obtained as a fitting result with the defined boundary features and with the at least one target current-related value. For instance, a least-squares fit may be executed for this purpose. The fitting algorithm may maintain the at least one target current-related value fixed, and may modify parameters which comply with the defined structural and electrical features, the defined distribution features and the defined amounts but are modifiable without contradiction to these definitions. For example, while metallic material and shape of the wiring elements, a hexagonal Voronoi pattern and a number of wiring elements of a wiring plane may be defined to be fixed and a minimum ampacity to be achieved may be defined, the side lengths of the Voronoi cells as well as the hole or drill diameter of the wiring elements may be variable fitting parameters.

In an embodiment, the method comprises defining the distribution of the wiring elements in accordance with said requirements using an artificial intelligence module. Component carrier design may be supported by artificial intelligence, which may be trained to consider the defines features as well as the at least one target current-related value mandatory, while considering other parameters as modifiable. On this basis, the artificial intelligence module may execute a component carrier design task. Such an artificial intelligence module may be trained with historic component carrier design files complying with certain defined features and with one or more target current-related values. For instance, such an artificial intelligence module may involve one or more elements of artificial intelligence from a group consisting of machine learning, neural networks, Fuzzy logic, deep learning algorithms, etc.

In an embodiment, the method comprises manufacturing the component carrier in accordance with the defined distribution of wiring elements. For example, the output of the method (which may be executed by a processor, by artificial intelligence, and/or by a human being such as a design engineer) may be a design file including information for manufacturing a component carrier in the real world. For instance, such a design file may include a set of parameter values needed for carrying out the manufacturing method for manufacturing the component carrier. The manufactured component carrier may then have the properties corresponding to the defined input features, corresponding to the obtained output distribution and complying with the at least one target current-related value.

In an embodiment, the wiring elements function for distributing electric power in the component carrier. This may be particularly advantageous for high performance computing applications, artificial intelligence applications, processor applications, and the like requiring a large amount of electric energy during operation.

In an embodiment, some of the wiring elements function for distributing signals in the component carrier. The arrangement of wiring elements in a wiring plane in rows with equidistant wiring elements may also support a reliable signal transport.

In an embodiment, some of the wiring elements function for providing a reference potential, in particular a ground potential in the component carrier. Also a ground potential or the like may be required for operating a surface mounted component.

In an embodiment, some of the wiring elements functioning for distributing electric power or signals or for providing a reference potential (such as a ground potential) are those provided on the first row or on the second row or on a third row. It is also possible that some other of the wiring elements with a different function are provided in another one of the first row or the second row or the third row. For example, each of the rows may have a separate function. Wiring elements of the first row may contribute to a first electric function, whereas wiring elements of a second row may contribute to another electric function. If wiring elements of a third row are present, they may provide a third electric function, and so on.

In an embodiment, the method comprises arranging the wiring elements for adjusting a number of wiring elements in the wiring plane complying with a predefined specification. A specification may define attributes concerning the electric functionality of a wiring plane or of the component carrier to be designed as a whole. The wiring elements may then be arranged in the first row, the second row, and optionally in further rows so as to comply with the specification. Such a process may be carried out manually, or preferably automatically (for instance by executing a fitting routine and/or by applying artificial intelligence).

In an embodiment, the method comprises arranging the wiring elements for adjusting a current carrying capability of the wiring elements in the wiring plane. When designing the arrangement of the wiring elements, the achievement of a predefined current carrying capability per cross-sectional metal area of the wiring elements, for instance current density (i.e. current per area) of 0.5 A to 15 A/mm$^2$, may be considered as a boundary condition which shall be fulfilled by the arrangement of the wiring elements to be designed.

In an embodiment, the method comprises determining at least one of a spatial distribution, a land diameter, a hole or drill diameter and/or a functional grouping of the wiring elements complying with a predefined specification. Other parameters may be considered for the design of the wiring elements as well.

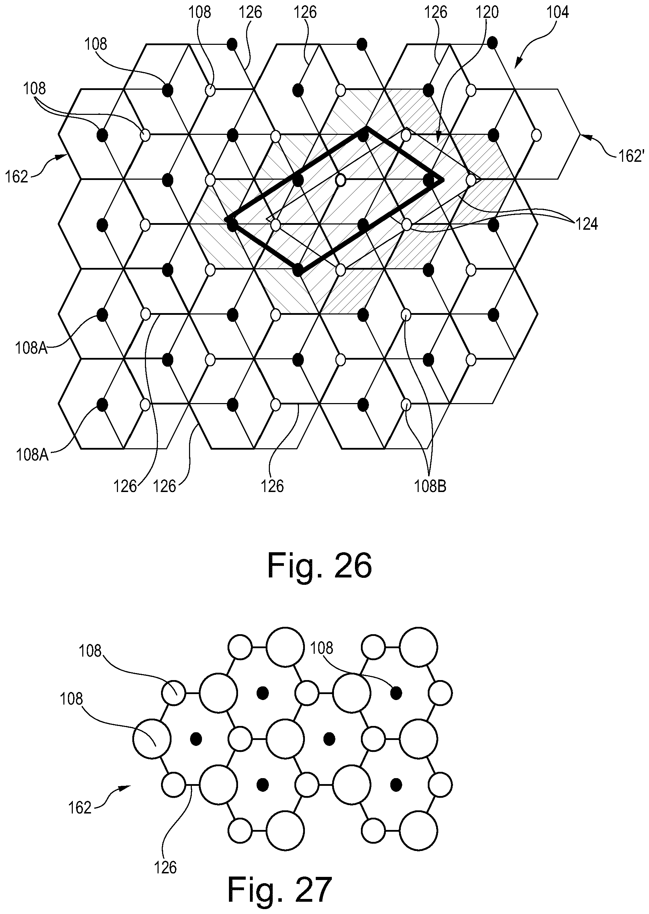

In an embodiment, the method comprises arranging the wiring elements in accordance with hexagonal Voronoi cells around respective wiring elements and by combining sets of wiring elements of neighbouring hexagonal Voronoi cells to four-sided blocks, in particular to parallelogram-type blocks (see for example Figure 26). Voronoi cells may provide a virtual distribution of directly connected cells without gaps in between and may provide a proper basis for a symmetric arrangement of wiring elements. The definition of four-sided blocks, in particular parallelogram-type blocks, may further refine the designed arrangement of wiring elements.

For example, different wiring elements may have a different length (for example for bridging between two layers, five layers, etc.). Adjusting the shape of wiring elements may also have an impact on their functionality. For example, flatness or low roughness of a wiring element may also be a target property because of an impact on attributes such as conductivity, etc.

In an embodiment, the component carrier comprises a stack which comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, for example fibers impregnated with the above-mentioned resins is called prepreg. These prepregs are often named after their properties for example FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide ($Al_2O_3$) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide ($Ga_2O_3$), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

In an embodiment, the component carrier related body is a laminate-type component carrier. In such an embodiment, the component carrier is a compound of multiple layer structures which are stacked and connected together by applying a pressing force and/or heat.

The aspects defined above and further aspects of the invention are apparent from the examples of embodiment to be described hereinafter and are explained with reference to these examples of embodiment.

Figure 1 illustrates a cross-sectional view of a component carrier according to an exemplary embodiment of the invention.

Figure 2 illustrates a plan view of a wiring plane of the component carrier according to Figure 1.

Figure 3 illustrates a plan view of a wiring plane of a component carrier according to an exemplary embodiment of the invention.

Figure 4 illustrates a plan view of a wiring plane of a component carrier according to an exemplary embodiment of the invention.

Figure 5 illustrates a cross-sectional view of part of a component carrier according to an exemplary embodiment of the invention.

Figure 6 illustrates a plan view of part of a wiring plane of the component carrier according to Figure 5.

Figure 7 illustrates constituents of a computer-based system for defining a distribution of wiring elements for a component carrier to be designed, and illustrates a table with parameters defining structure and performance of a component carrier according to an exemplary embodiment of the invention.

Figure 8 illustrates a plan view of wiring elements of a detail of a wiring plane of a component carrier according to an exemplary embodiment of the invention.

Figure 9 illustrates a plan view of part of wiring planes of a component carrier according to an exemplary embodiment of the invention illustrating mechanically drilled through holes of a core and laser drilled through holes of a build-up.

Figure 10 illustrates a plan view of a wiring plane of a component carrier according to an exemplary embodiment of the invention.

Figure 11 illustrates a cross-sectional view of a component carrier and a plan view of a wiring plane of the component carrier according to an exemplary embodiment of the invention.

Figure 12 illustrates a plan view of another wiring plane of the component carrier according to Figure 11.

Figure 13 illustrates a plan view of an overlay of the wiring planes of Figure 11 and Figure 12.

Figure 14 illustrates a plan view of part of a wiring plane of a component carrier according to an exemplary embodiment of the invention.

Figure 15 illustrates a cross-sectional view of part of a component carrier according to an exemplary embodiment of the invention.

Figure 16 illustrates a plan view of part of a wiring plane of a component carrier according to an exemplary embodiment of the invention.

Figure 17 illustrates a plan view of different wiring planes of a component carrier according to an exemplary embodiment of the invention.

Figure 18 illustrates a similar view as Figure 17 indicating additional conductive areas around wiring elements.

Figure 19 illustrates a detail of Figure 18.

Figure 20 illustrates a plan view of a wiring plane of a component carrier according to an exemplary embodiment of the invention to which an additional wiring element is added.

Figure 21 illustrates a plan view of a conventional wiring plane of a component carrier.

Figure 22 illustrates a plan view of different wiring planes of a component carrier according to an exemplary embodiment of the invention.

Figure 23 illustrates a plan view of a wiring plane of a component carrier according to an exemplary embodiment of the invention.

Figure 24 illustrates a plan view of a wiring plane of a component carrier according to an exemplary embodiment of the invention.

Figure 25 illustrates a plan view of a wiring plane of a component carrier according to an exemplary embodiment of the invention.

Figure 26 illustrates a plan view of different wiring planes of a component carrier according to an exemplary embodiment of the invention.

Figure 27 illustrates a plan view of a wiring plane of a component carrier according to an exemplary embodiment of the invention.

The illustrations in the drawings are schematic. In different drawings, similar or identical elements are provided with the same reference signs.

Before referring to the drawings, exemplary embodiments will be described in further detail, some basic considerations will be summarized based on which exemplary embodiments of the invention have been developed.

According to an exemplary embodiment of the invention, a method of defining the distribution of wiring elements from a predefined, desired or known current value to be transmitted from a first to a second main surface of a component carrier, or part thereof, is provided. The component carrier comprises a (preferably laminated) layer stack comprising at least one electrically conductive layer structure (preferably a plurality of electrically conductive layer structures) and at least one electrically insulating layer structure (preferably a plurality of electrically insulating layer structures). A plurality of wiring elements are arranged in a wiring plane to form a first row of equidistant wiring elements arranged along a straight direction within the wiring plane. Moreover, a second row of equidistant wiring elements is arranged along the straight direction within the wiring plane (preferably, but not necessarily, the second row of equidistant wiring elements may be offset along the straight direction with respect to the wiring elements of the first row.

For defining the distribution of wiring elements, being compliant with the target current value (for instance an ampacity of the wiring elements), the method may comprise:

-   Definition of mechanical and electrical features of the wiring elements;
-   Definition of distribution features characterizing a distribution of the wiring elements;
-   Definition of the amounts of the distributed wiring elements to provide a required current density in the available area;
-   Definition of the distribution of the wiring elements fulfilling the known or target current value requirements in dependence of the defined mechanical and electrical features of the wiring elements, the defined amounts of the distributed wiring elements, and the defined distribution features.

Such an approach may design a component carrier in accordance with the described set of meaningful definitions or criteria as input parameters. The remaining degrees of freedom of arranging wiring elements of the component carrier may then be used for adapting the design under consideration of the target current density value. In particular, a ratio in a range from 6% to 11% wiring elements metal area per unit area in a wiring plane has turned out as a highly appropriate compromise to achieve a sufficiently high current carrying capacity of the wiring elements versus the targeted current density, while simultaneously ensuring electric reliability and safety.

What concerns the above-mentioned defined mechanical and electrical features, these may include hole diameter of the wiring elements, a copper cross section of the wiring elements (for instance formed by the wall plating), land dimensions, and the allowed temperature difference (Delta T). Also a current ampacity (or current carrying capacity or capability) of the wiring elements may be taken into account. Resistivity of the metallic material of the wiring elements (for instance for electroplated copper in a range from 1.7 $10^{-6}$ $\Omega$/cm to 2.2 $10^{-6}$ $\Omega$/cm) may be considered as well as electrical feature.

Said distribution features may include one or more parameters indicating or quantifying equidistance of the wiring elements of a respective row (in particular depending on a hole diameter and/or a land dimension). In addition, an offset value indicating or quantifying an offset between wiring elements of the first and the second row may be taken into account in this context. Moreover, a degree of overlap of different rows of different design domains (e.g. power domain) may be considered in the framework of defining distribution features. Yet another aspect which may be defined in terms of distribution features may be shape and/or dimensions of Voronoi cells into which a wiring plane may be subdivided.

What concerns the above-mentioned amounts of the distributed wiring elements, one or more parameters indicating such an amount may depend on the mechanical and electrical features and/or on the distribution features.

With the above-mentioned approach, it may be possible to design for example an HPC (high-performance computing) substrate core. Power feeding of a component carrier may be defined by the design of the wiring elements of the respective wiring plane.

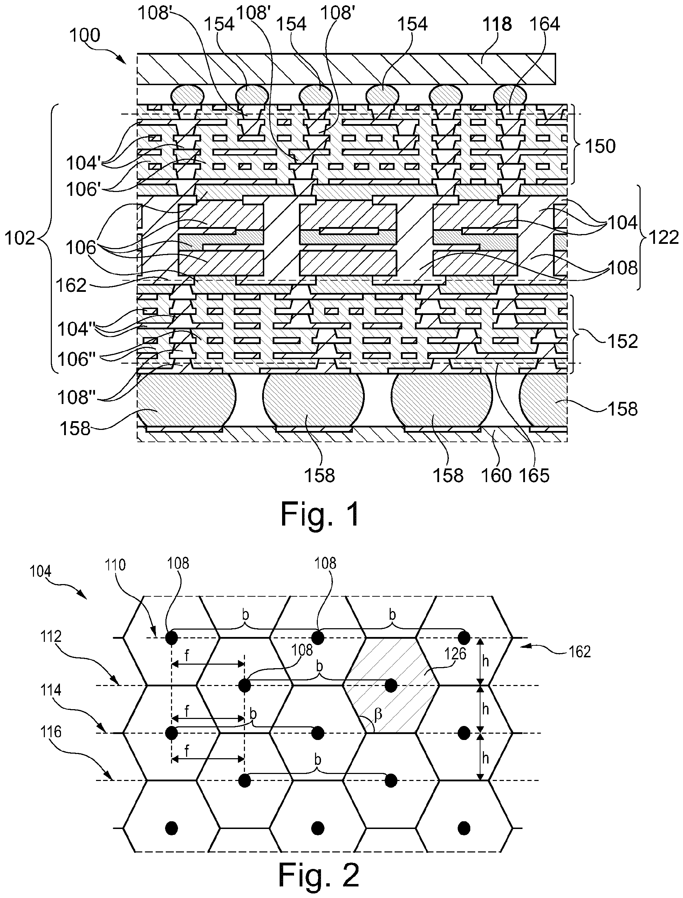

**Figure 1** illustrates a cross-sectional view of a component carrier 100 according to an exemplary embodiment of the invention. **Figure 2** illustrates a plan view of a wiring plane 162 of the component carrier 100 according to Figure 1.

Component carrier 100 may be an integrated circuit (IC) substrate or a printed circuit board (PCB). The component carrier 100 may comprise a laminated layer stack 102 comprising, in a core 122 (which may be, for example, a multilayer core), one or more electrically conductive layer structures 104 and one or more electrically insulating layer structures 106. For example, the one or more electrically conductive layer structures 104 may comprise patterned metal layers (such as patterned copper foils or patterned deposited copper layers) and vertical through connections, for example copper filled vias, which may be created by drilling and plating. The one or more electrically insulating layer structures 106 may comprise a respective resin (such as a respective epoxy resin), preferably comprising reinforcing particles therein (for instance glass fibers or glass spheres). For example, the one or more electrically insulating layer structures 106 may be made of FR4. The one or more electrically insulating layer structures 106 may also comprise resin layers being free of glass (in particular glass fibers).

As shown, a plurality of through-holes are formed in central core 122 of stack 102, for example by mechanically drilling. The through-holes in the core 122 may be filled, partially or entirely, with electrically conductive material, such as copper, for example by plating. Inside of the central electrically insulating layer structure 106, a plurality of wiring elements 108, forming part of the central electrically conductive layer structure 104, are provided.

As shown in Figure 1 as well, an upper build-up 150 and a lower build-up 152 are formed on top and on the bottom of the core 122, respectively. The bottom sided build-up 152 can be constructed in a similar way as the top-sided build-up 150.

Upper build-up 150 comprises a plurality of further electrically conductive layer structures 104' and electrically insulating layer structures 106'. Inside of the further electrically insulating layer structures 106', a plurality of further wiring elements 108', forming part of the further electrically conductive layer structures 104', are provided.

Correspondingly, the lower build-up 152 comprises a plurality of further electrically conductive layer structures 104" and electrically insulating layer structures 106". Inside of the further electrically insulating layer structures 106", a plurality of further wiring elements 108", forming part of the further electrically conductive layer structures 104", are provided.

More specifically, a plurality of metal filled laser vias are provided in each of the build-ups 150, 152, forming said further wiring elements 108', 108". The further wiring elements 108', 108" have a higher density (i.e. a larger number of wiring elements per area or volume) and smaller dimensions than the metal filled mechanically drilled through-holes extending through the core 122 and forming the wiring elements 108. Preferably, the wiring elements 108 have a cylindrical shape and the further wiring elements 108' and 108" have frustoconical shape.

On top of the upper build-up 150 and thus on an upper main surface of stack 102, a component 118 is surface mounted by an attachment technology such as soldering, thermocompression bonding, hybrid bonding, wire bonding, gluing or other metal to metal interdiffusion techniques. For example, component 118 is a semiconductor chip or a semiconductor package, for instance comprising at least one power semiconductor chip, a microprocessor, a central processing unit, a graphical processing unit, an artificial intelligence chip and/or another electronic component having a high electronic performance. The surface mounted component 118 is connected with the stack 102 by solder structures 154. It is also possible that a plurality of surface mounted components 118 are mounted on the stack 102.

At the bottom of the bottom-sided build-up 152, the stack 102 is mounted by further solder structures 158 on a mounting base 160, such as a printed circuit board (PCB), or mounted through the use of Land Grid Array pads into a socket, which is hosted for example by the PCB. A dimension in at least one direction of the further solder structures 158 can be bigger than a corresponding dimension of at least one direction of the solder structures 154.

Electric power and electric signals may be guided through the core 122 and the build-ups 150, 152 and therefore between the mounting base 160 and the surface mounted component 118. Electricity transported through the stack 102 and therefore through the core 122 may include electric power and/or electric signals. Furthermore, it may be possible to provide at least one electric reference potential (for example a ground potential) at one or more wiring elements 108 extending through the core 122.

As can be taken from the above description, the electric interconnection and the supply of electricity of component carrier 100 can be very challenging, in particular when a high current density, i.e. current per area (of for instance of 0.5 A/mm² to 15 A/mm²) and/or a high number of I/O connections of the surface mounted component 118 (for instance at least 10 or even at least 50 I/O connections) are required or desired. In order to meet these challenging demands concerning electric performance of the component carrier 100, wiring elements 108, 108', 108" in any of the electrically insulating layer structures 106, 106', 106" may be modelled and designed in a way as described below referring to Figure 2 and the subsequent figures. To put it shortly, a respective planar wiring layer may be defined, in particular wiring plane 162 extending through core 122. Additionally or alternatively, at least one other wiring plane may be designed, for instance a wiring plane 164 in upper build-up 150 and/or a corresponding wiring plane 165 in lower build-up 152.

In the following, it will be described on the example of wiring plane 162 as so how its wiring elements 108 can be designed according to an exemplary embodiment of the invention. This will be explained for wiring plane 162 of core 122, wherein the wiring plane 164 in upper build-up 150 and/or the wiring plane 165 in lower build-up 152 may be designed accordingly.

Now referring to Figure 2 showing a cross-section of Figure 1 through wiring plane 162, the corresponding electrically conductive layer structure 104 comprises a plurality of wiring elements 108. Said wiring elements 108 are arranged in wiring plane 162 and embedded in a dielectric matrix provided by the corresponding electrically insulating layer structure 106.

As shown in Figure 2, a first group of wiring elements 108 are arranged along a first row 110 of equidistant wiring elements 108 arranged along a straight direction (a horizontal direction according to Figure 2) within the wiring plane 162. More specifically, adjacent equidistant wiring elements 108 of the first row 110 all have same mutual distance, b, from each other. As shown as well in Figure 2, a second group of wiring elements 108 are arranged along a second row 112 of equidistant wiring elements 108 which are arranged along the same straight direction (the mentioned horizontal direction according to Figure 2) within the wiring plane 162 as the wiring elements 108 of the first row 110. More specifically, adjacent equidistant wiring elements 108 of the second row 112 all have to same mutual distance, b, from each other. Hence, the distance or spacing, b, may be the same for the first row 110 and for the second row 112. Thus, a mutual distance, b, between adjacent equidistant wiring elements 108 of the first row 110 equals to a mutual distance, b, between adjacent equidistant wiring elements 108 of the second row 112.

However, the second row 112 of equidistant wiring elements 108 is offset along the straight direction with respect to the wiring elements 108 of the first row 110 by an offset value, f. Descriptively speaking, if the wiring elements 108 of the second row 112 would be shifted along the horizontal straight direction by the offset value, f, said wiring elements 108 would be in alignment with the sequence of the wiring elements 108 of the first row 110. Furthermore, the offset value, f, of the equidistant wiring elements 108 of the second row 112 with respect to the equidistant wiring elements 108 of the first row 110 along the straight direction is 1/2 of a mutual spacing, b, between adjacent equidistant wiring elements 108 of the first row 110 or of the second row 112.

Furthermore, the second row 112 is spaced with respect to the first row 110 along a further straight direction perpendicular to the horizontal straight direction by a measure, h. In Figure 2, said further straight direction extends vertically. In other words, the second row 112 is aligned parallel to the first row 110.

In addition to the wiring elements 108 of the first row 110 and of the second row 112, the wiring plane 162 of Figure 2 comprises a third row 114 next to the second row 112 and having an arrangement of wiring elements 108 as the first row 110. Furthermore, a fourth row 116 is arranged next to the third row 114 and has an arrangement of wiring elements 108 as the second row 112. Thus, a highly symmetric arrangement of wiring elements 108 is provided in the wiring plane 162.

Although only some wiring elements 108 are shown in the first row 110, in the second row 112, in the third row 114, and in the fourth row 116 in Figure 2, the described sequence of wiring elements 108 may be continued in accordance with the mentioned ordering scheme. Furthermore, also additional rows may be provided (not shown).

Again referring to Figure 2, all wiring elements 108 are arranged at centers of hexagonal virtual cells 126 into which the wiring plane 162 may be virtually divided. As shown, each of said hexagonal virtual cells 126 are adjacent one to the other without gaps in between. Thus, adjacent hexagonal virtual cells 126 share a respective side. Descriptively speaking, the entire wiring plane 162 may be subdivided into the hexagonal virtual cells 126 which are arranged side by side without gaps in between. Each of said hexagonal virtual cells 126 is delimited by a regular hexagon having six angles, β, with 120° each. The hexagonal virtual cells 126 form a Voronoi pattern.

For example, the wiring elements 108 of the wiring plane 162 may function for distributing electric power in the component carrier 100, more specifically in the core 122 thereof. Such electric power may be used for operating surface mounted component 118. For example, some of the wiring elements 108 may function for distributing electric signals in the component carrier 100. For instance, said signals may be signals for driving the surface mounted component 118 and/or signals provided by surface mounted component 118. Yet other of the wiring elements 108 may function for providing a reference potential, in particular a ground potential, in the component carrier. Yet other of the wiring elements 108 may function for distributing heat. For properly operating a surface mounted electronic component 118, it may also be necessary to provide a ground potential. In an embodiment, wiring elements 108 functioning for distributing electric power or signals or a ground potential may be those provided on the first row 110 or on the second row 112 or on the third row 114 or on the fourth row 116. Other of the wiring elements 108 with a different function may be provided in another one of the first row 110 or the second row 112 or the third row 114 or the fourth row 116.

When designing component carrier 100, the wiring elements 108 may be arranged so as to comply with a predefined specification, for example in terms of current carrying capability or ampacity. In this context, the above-mentioned parameters (such as b, f, h) and/or other parameters and/or attributes (for instance the design of virtual cells 126) may be selected appropriately for achieving compliance with the specification or the requirements of at least one target attribute, function or property of the component carrier 100. For example, this can be done by a computer fit or manually.

To put it shortly, Figure 2 shows a plan view of wiring plane 162 illustrated in Figure 1. Each wiring plane 162, 164, 165, ..., can be subdivided into a plurality of Voronoi cells which are here embodied as hexagonal virtual cells 126. As shown, the regular hexagonal virtual cells 126 have six sides with a mutual 120° angle in between and being directly in contact with adjacent cells. Thereby, no empty space or area is created between the regular hexagonal virtual cells 126. By this virtual division of the respective wiring plane 162, 164, 165 in virtual cells 126, the entire area or part thereof may be covered. Wiring elements 108, 108', 108" of the electrically conductive layer structures 104, 104', 104" of the respective wiring plane 162, 164, 165 may be arranged all in centres of the regular hexagonal virtual cells 126. By taking this measure, a regular pattern is obtained which allows to maintain minimum distances between adjacent wiring elements 108, 108', 108", which may be required for electric safety purposes according to a specification to be met. By the arrangement in the various rows 110, 112, 114, 116, and by the mutual offset, f, between adjacent rows 110, 112, 114, 116, a highly symmetric pattern may be achieved which may meet simultaneously electric demands of a certain application. For optimizing a design, it may be possible to fit the position of the wiring elements 108, 108', 108" and/or the dimension and positions of the virtual cells 126 to achieve appropriate, or even the best, results. For instance, fitting parameters may be a length of a side of the regular hexagonal virtual cells 126, an area of the wiring elements 108, 108', 108" in the respective wiring plane 162, 164, 165, the offset value, f, etc.

Although not shown in Figure 1, a surface finish may be provided, such as a gold layer and/or a layer of solder resist.

Furthermore, it is possible - also in the embodiment of Figure 1 - that one or more components are embedded in the stack 102, in particular in the core 122. Therefore, the patterned wiring 108, 108', 108" may comprise at least one empty location or vacancy. Even if the embedding is strategically planned to avoid disruption of the power distribution network of wiring elements 108, 108', 108", the embedded component can be part of the power distribution network itself. Hence, there may be a possibility of having an empty location, in particular in the straight disposition of the vertical structures. Even if the embedding is strategically planned to avoid disruption of the power distribution network of wiring elements 108, 108', 108", the embedded component can be part of the power distribution network itself. Hence, there may be a possibility of having an empty location, in particular in the straight disposition of the vertical structures.

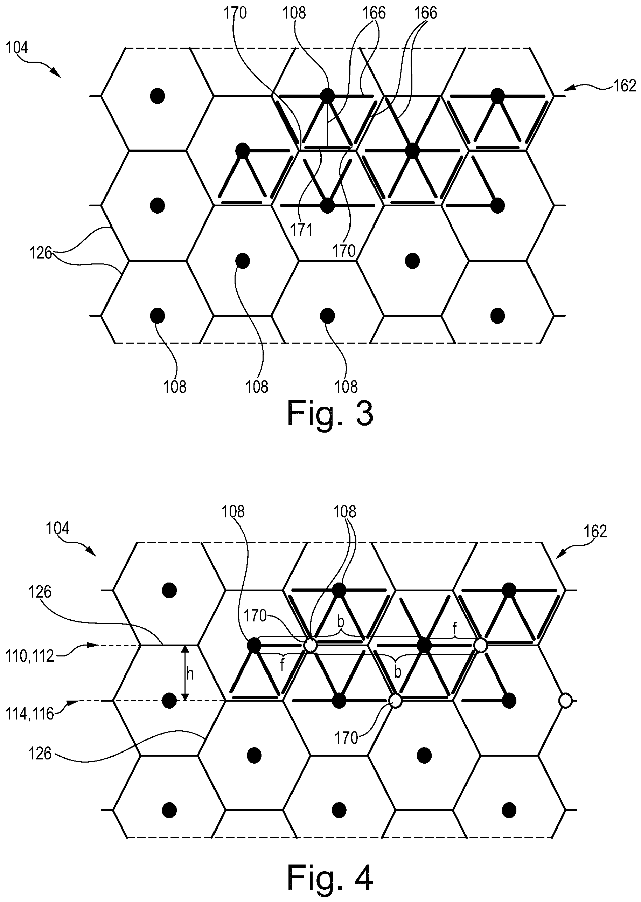

Figure 3 illustrates a plan view of wiring plane 162 of the component carrier 100 according to an exemplary embodiment of the invention. Figure 3 shows further auxiliary lines 166 extending from a respective wiring element 108 to a corner 170 or a side 171 of the hexagonal virtual cells 126. Also such parameters may be design parameters for designing a component carrier 100 in compliance with predefined target electric properties.

Figure 4 illustrates a plan view of a wiring plane 162 of a component carrier 100 according to another exemplary embodiment of the invention.

In addition to wiring elements 108 located in centers of the respective hexagonal virtual cells 126, Figure 4 shows an embodiment in which in addition another part of the wiring elements 108 are arranged at corners 170 of the hexagonal virtual cells 126. For example, the part of the wiring elements 108 arranged at the centers of the hexagonal virtual cells 126 may provide a first electric function (for example a power supply function), and the other part of the wiring elements 108 arranged at the corners 170 of the hexagonal virtual cells 126 may provide a second electric function (for example a signal transmission function) being different from the first electric function.

In Figure 4, the first row 110 of equidistant wiring elements 108 and the second row 112 of equidistant wiring elements 108 both extend along the same horizontal straight direction, but are also in alignment what concerns a further straight direction perpendicular to said horizontal straight direction. In the example of Figure 4, rows 110, 112 are defined by a sequence of wiring elements 108 from first row 110, then from second row 112, then from first row 110, then from second row 112, and so on. For mapping the wiring elements 108 of the second row 112 onto the wiring elements 108 of the first row 110, it is thus sufficient to shift the wiring elements 108 of the second row 112 with respect to the wiring elements 108 of the first row 110 by the offset value, f, along said horizontal straight direction towards the left-hand side of Figure 4. In the illustrated embodiment, the wiring elements 108 in the centers of the hexagonal virtual cells 126 may form the first row 110 while the wiring elements 108 in the corners 170 of the hexagonal virtual cells 126 may form the second row 112. Here, the offset value, f, of the equidistant wiring elements 108 of the second row 112 with respect to the equidistant wiring elements 108 of the first row 110 along the straight direction is 1/3 of a mutual spacing, b, between adjacent equidistant wiring elements 108 of the first row 110 or of the second row 112.

As shown, a smallest distance (which equals to the offset value, f, in the shown embodiment) of a wiring element 108 of the second row 112 from a wiring element 108 of the first row 110 is 1/3 of a mutual spacing, b, between adjacent equidistant wiring elements 108 of the first row 110 or of the second row 112.

In Figure 4, the second row 112 is aligned with the first row 110. A third row 114 and a fourth row 116 are also aligned which each other but are spaced with respect to the first row 110 and the second row 112 along the perpendicular straight direction by the offset value, h.

It is also possible that the wiring elements 108 of the wiring plane 162 of Figure 4 are grouped into a plurality of wiring element groups (which may correspond to the various rows 110, 112, 114, 116) of different electric functions, for instance are assigned to different electric voltage levels and/or to different electric current carrying capabilities.

As already mentioned, the wiring elements 108 of Figure 4 are not only arranged in centres of the hexagonal virtual cells 126, but also at corners 170 thereof. For instance, the wiring elements 108 in the centres may have a first electric function, whereas the wiring elements 108 on the corners 170 may have another second electric function. For example, the wiring elements 108 in the centres and in the corners 170 may relate to different electric potentials. It is also possible that the wiring elements 108 in the centres provide electric power, whereas the wiring elements 108 in the corners 170 provide reference potentials or signals (or vice versa).

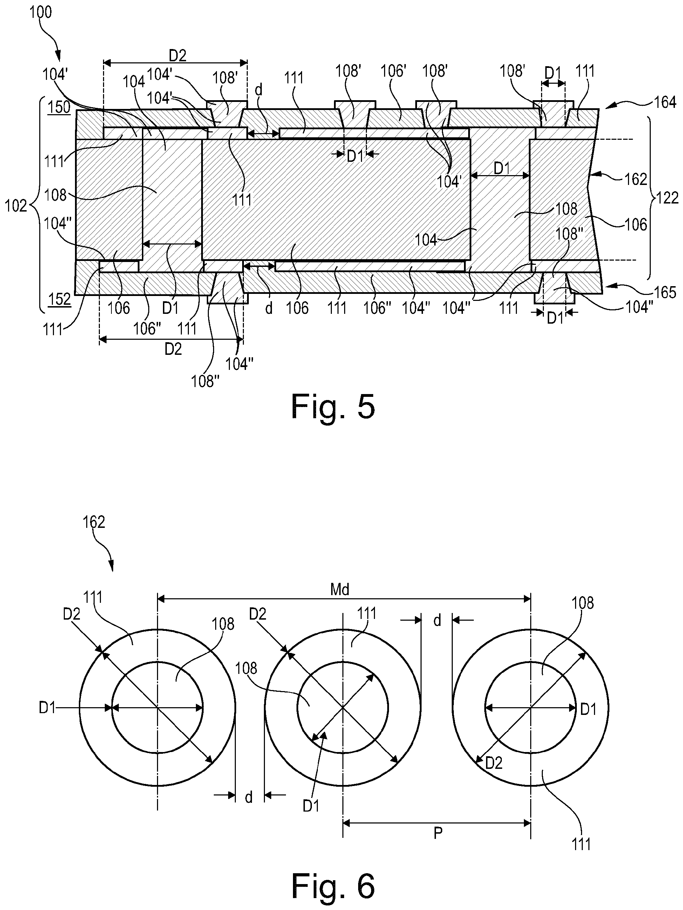

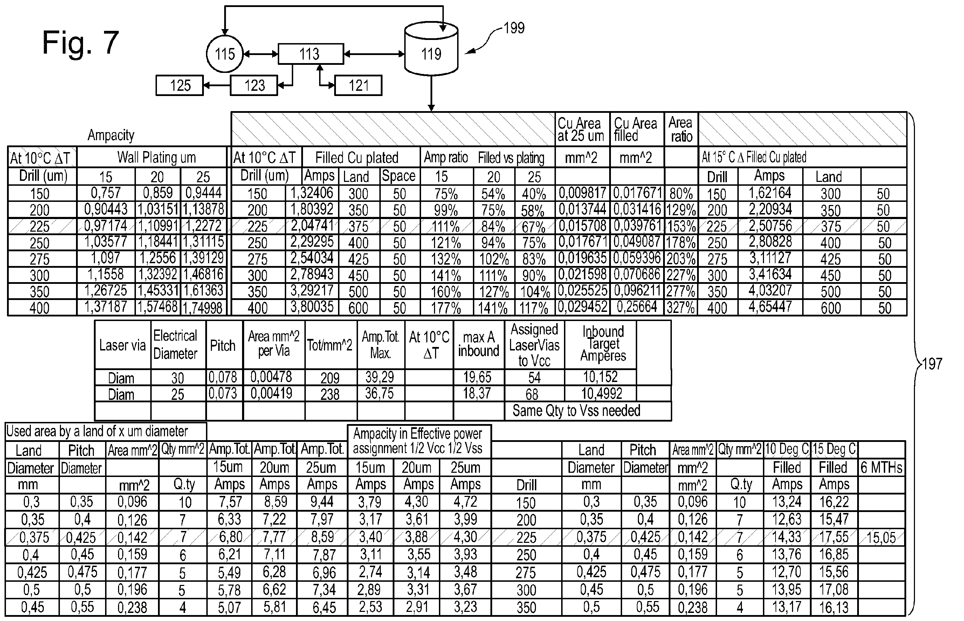

**Figure 5** illustrates a cross-sectional view of part of a component carrier 100 according to an exemplary embodiment of the invention. **Figure 6** illustrates a plan view of part of a wiring plane 162 of the component carrier 100 according to Figure 5. **Figure 7** illustrates constituents of a computer-based system 199 for defining a distribution of wiring elements 108 for component carrier 100 to be designed, and illustrates a table 197 with parameters defining structure and performance of the component carrier 100 according to an exemplary embodiment of the invention. When a component carrier 100 designed according to Figure 7 is designed, the model and the parameters and attributes according to Figure 5 and Figure 6 may be taken into account.

Referring to Figure 5, a detail of core 122 with connected portions of build-ups 150, 152 are illustrated. In particular, conductive areas 111 - which may also be denoted as lands - are provided for interconnecting wiring elements 108, 108', 108". Figure 5 also shows respective distances, d, between adjacent conductive areas 111 of a respective wiring plane (indicated with reference signs 162, 164, 165, in a similar way as in Figure 1. Moreover, diameters of wiring elements 108, 108', 108" are indicated with reference signs D1. Furthermore, diameters of lands or conductive areas 111 are shown with reference sign D2. Also a broader surface area of the frustoconical shaped laser vias may be considered.

As shown in Figure 5, the upper conductive area 111 assigned to wiring element 108 on the right-hand side of Figure 5 is connected to a plurality of further wiring elements 108'. As a preferred embodiment, the upper conductive area 111 assigned to wiring element 108 on the left-hand side of Figure 5 is connected to a single further wiring element 108'. Hence, said further wiring elements 108' may also be connected directly to said annular conductive area 111 in an efficient way. In the embodiment of Figure 5, each of the other conductive areas 111 is connected only to a single assigned further wiring element 108' or 108".

Now referring to Figure 6, a plan view of wiring elements 108 of a wiring plane (for instance 162) is shown which are arranged side by side. In addition to the respective wiring element 108, a corresponding land or conductive area 111 is shown as well. A land or conductive area 111 may be a circular or annular structure extending laterally beyond an assigned wiring element 108. Adjacent wiring elements 108 with lands or conductive areas 111 are spaced by a distance, d. A diameter of a wiring element 108 is denoted as D1. A diameter of a land or conductive area 111 is denoted as D2. Parameter values such as D1, D2 and d can be used as design parameters or fitting parameters for optimizing the electric performance of a wiring plane 162.

When designing component carrier 100, this may comprise determining a spatial distribution of wiring elements 108 and lands or conductive areas 111, land diameter D2, hole diameter D1 and a functional grouping of the wiring elements 108 complying with a predefined specification (such as a design file). In other words, the specification may define target properties of the component carrier 100 to be designed and to be subsequently manufactured. Said distribution of wiring elements 108 including lands or conductive areas 111, the parameters d, D1 and D2, as well as the grouping of the wiring elements 108 to provide a certain (in particular electric) function in the framework of the component carrier 100 may then be adjusted accordingly. Spacing, d, between adjacent lands or conductive areas 111 of adjacent wiring elements 108 may be a further design parameter to be adjusted in this context. Also a minimum distance for a hexagonal virtual cell 126, Md, and/or a pitch, P, may be introduced in the determination process. The pitch, P, may define the center-to-center distance between adjacent wiring elements 108. Thus, the mentioned considerations may be taken into account when defining a core drilling set up. By correspondingly executing core drilling and at least partially filling with electrically conductive material (e.g. metal) resulting in a wiring element 108, a target ampacity of the component carrier 100 may be achieved.

Referring to Figure 6, the following formulas apply:

$$Md = \tfrac{1}{2}\,D2 + d + D2 + d + \tfrac{1}{2}\,D2$$

$$P = \tfrac{1}{2}\,D2 + d + \tfrac{1}{2}\,D2$$

The resulting minimum geometries are something that can be addressed modifying some of the same rules, which are driving the pitch, like for example the possibility of differentiating the diameter of the mechanically drilled through hole. The resulting pitch can then be modified to further enable other significant changes, such as enlarging some holes in respect of others. This may then establish a differential contribution to the overall characteristics of the substrate.

Now referring to Figure 7, a computer-based system 199 for defining a distribution of wiring elements 108 for a component carrier 100 to be designed is illustrated. Furthermore, Figure 7 shows a table 197 with parameters defining structure and performance of the component carrier 100.

When designing a component carrier 100 to be manufactured subsequently, it may be possible to define the distribution of the wiring elements 108 in accordance with certain requirements by a processor 113. Said requirements may be correlated with some of the parameter values of table 197, which may be stored in a database 119 (which may be realized by a mass storage device such as a hard disk). Processor 113, which may form part of a computer (not shown), may carry out calculations for virtually designing component carrier 100. For defining the distribution of the wiring elements 108 for component carrier design supported by the processor 113, it may be possible to execute a suitable fitting algorithm. Said fitting algorithm may vary several degrees of freedom but maintains a target current-related value, such as a target ampacity of the designed features into the component carrier 100, fixed. A set of defined parameters may be considered as well as fixed boundary conditions for the fit. In order to support processor 113 during virtually designing a component carrier 100, a distribution of the wiring elements 108 may be determined in accordance with said requirements using an artificial intelligence module 115 (which may for instance comprise a neural network). As shown, computer-based system 199 may also comprise an input/output unit 121 (such as a user interface) by which a human operator, such as a design engineer, may input parameters to be considered for the design or fit, in particular by executing corresponding software code. Furthermore, output parameters of a design or fit may be output to the human operator by input/output unit 121. When a design for component carrier 100 has been defined in compliance with one or more target current-related values (such as a target ampacity for the electrically conductive structures, or the current density) and meeting all below defined inputs definitions, computer-based system 199 may output a correspondingly constructed design file 123 summarizing all parameters needed for manufacturing the component carrier 100. Such a design file 123 may be sent (in particular after approval by the human operator) to a component carrier manufacturing apparatus 125 for physically manufacturing the component carrier 100 in accordance with the derived design. Thus, the component carrier 100 may then be manufactured in accordance with the design file 123 including the defined distribution of wiring elements 108.

In the following, it will be explained in further detail how the distribution of wiring elements 108 of the component carrier 100 to be manufactured can be defined. It should be mentioned that not only the arrangement of wiring elements 108 of wiring plane 162 can be defined, but also (for example in a corresponding way) the arrangement of further wiring elements 108', 108", ... in one or more further wiring planes 164, 165, .... However, the following description focuses on the distribution of wiring elements 108 in wiring plane 162.

As already mentioned, the definition of a distribution of wiring elements 108 may be accomplished in accordance with one or more target current-related values of an electric current to be transmitted through the component carrier 100 or part thereof. For instance, a target current-related value may indicate a current density, a current carrying capacity or a current carrying capacity per area of the component carrier 100 under development. More specifically, the target current-related value may specify that the current density shall be from 0.5 A/mm$^2$ to 15 A/mm$^2$ or more. The component carrier 100 to be developed may be constructed for example as shown in Figure 1 or in Figure 5. Moreover, such a component carrier 100 may have an arrangement of wiring elements 108 arranged in equidistant groups corresponding to rows 110, 112, for instance in a way as shown in Figure 2 or Figure 4. Wiring elements 108 of a corresponding wiring plane 162 may be defined for instance by the parameters shown in Figure 6.

For designing the distribution of wiring elements 108 compliant with a predefined target current-related value, the method may be based on the following inputs definitions:

- defining structural and electrical features of the wiring elements 108;
- defining distribution features indicative of a distribution of the wiring elements 108;
- defining amounts of the distributed wiring elements 108 to be provided in a respective area of the wiring plane 162.

On the basis of the predefined target current-related values, the method may then define or determine the distribution of the wiring elements 108 in dependence of the defined structural and electrical features of the wiring elements 108, the defined distribution features, and the defined amounts of the distributed wiring elements 108. For example, these predefined target current-related values can be considered such as addressing the ampacity of structures, the current density in specific areas, or a combination of the two.

Defining the structural and electrical features of the wiring elements 108 may include a definition of the hole diameter D1 (for instance drill diameter) for each of the wiring elements 108. It is also possible to define in this context a cross sectional area of the wiring elements 108. Also, wall plating-related parameters of the wiring elements 108 may be defined, for instance a thickness of a plated wall in a drill hole. Additionally or alternatively, a dimension (for instance diameter D2) of a land-type conductive area 111 directly connected with the wiring elements 108 may be defined as input parameter for the algorithm. A resistivity of the wiring elements 108 may be defined as well, for instance in accordance with a metal (such as copper) used for manufacturing the wiring elements 108.

For instance, defining the distribution features comprises arranging the wiring elements 108 of the second row 112 with an offset according to offset value, f, along the straight direction with respect to the wiring elements 108 of the first row 110. Defining the distribution features may also comprise arranging the wiring elements 108 at centers of hexagonal virtual cells 126 of the wiring plane 162, for instance as shown in Figure 2. Also in accordance with Figure 2, the definition of the distribution features may include arranging the wiring elements 108 so that a mutual distance, b, between adjacent equidistant wiring elements 108 of the first row 110 equals to a mutual distance, b, between adjacent equidistant wiring elements 108 of the second row 112.

The defined distribution features for the wiring elements 108 may also specify properties of a Voronoi pattern, for instance a hexagonal outline and a side length thereof, as well as a position of a respective wiring element 108 with respect to a Voronoi virtual cell (for instance a center or a corner 170). Also an equidistance parameter, an offset value, etc. may be defined.

Definition of the amount of the distributed wiring elements 108 may specify, for example, a number of wiring elements 118 in wiring plane 162, a metallic cross-sectional area of the wiring elements 108, etc.

Advantageously, the definition of the amount may be made dependent on the defined structural and electrical features and dependent on the defined distribution features. This may make it possible to consider also a correlation or interaction between the individual defined features or attributes.

An output of the method may be a design file 123 including all information needed for manufacturing the virtually designed component carrier 100 physically. Advantageously, an output of the manufacturing method may be a component carrier 100 having a ratio between an area value occupied by electrically conductive material of the wiring elements 108 within a unit area and an area value of said unit area of the stack 102, from a frontal view (i.e. from the top side of Figure 1 or Figure 5), in a range from 6% to 11%. Such a design may also comply with a target current-related value of a current density of $0.5 \text{ A/mm}^2$ to $15 \text{ A/mm}^2$. For example, the target current-related value may be a current density of at least 10 $\text{A/mm}^2$.

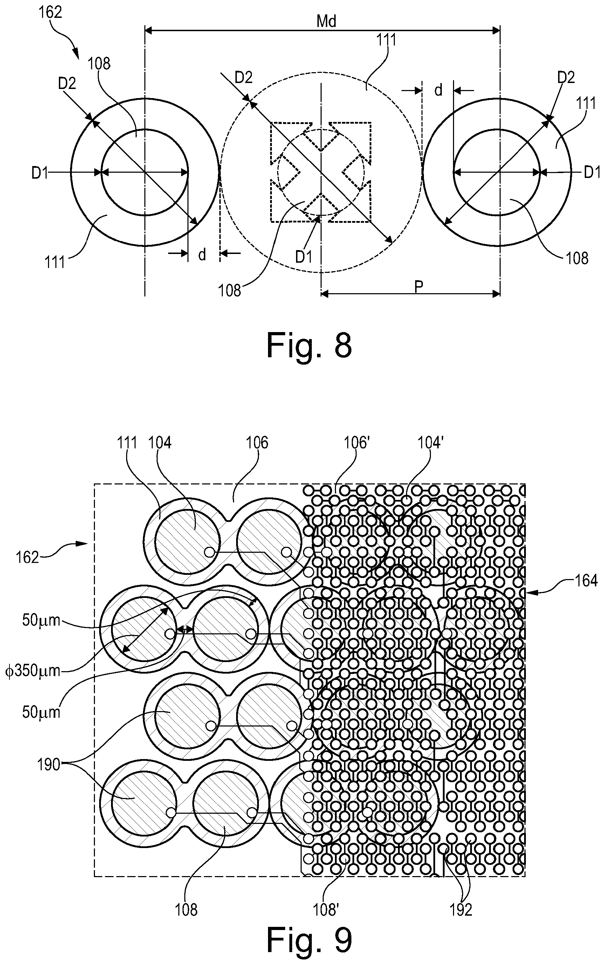

**Figure 8** illustrates a plan view of wiring elements 108 of a detail of a wiring plane 162 of a component carrier 100 according to an exemplary embodiment of the invention. In a nutshell, Figure 8 shows a similar scenario as Figure 6, wherein Figure 8 indicates the central wiring element 108 with larger dimensions than the exterior ones.

**Figure 9** illustrates a plan view of part of overlapping wiring planes 162, 164 of a component carrier 100 according to an exemplary embodiment of the invention illustrating mechanically drilled through holes 190 density per area of a core 122 and the density per the same area of laser drilled through holes 192 of a build-up 150. Hence, Figure 9 enables a geometrical comparison of mechanically drilled through holes 190 versus laser vias, i.e. laser drilled through holes 192. The comparison of laser via dimensions versus dimensions of plated through holes in the core 122 of the substrate-type component carrier 100 shows significant differences. In the illustrated example, diameters of the laser via lands are 60 $\mu$m. In contrast to this, the plated mechanical through holes lands have a diameter of 350 $\mu$m (related to 150 $\mu$m drilled holes), in the shown example. As shown in Figure 9, there may be major differences between the different geometries and even densities of the vertical metal structures within the substrate layers.

An entry point may be realized with small features but carrying lower currents and higher voltages. The central section of the substrate (i.e. its core 122) may handle a conversion to lower voltages and higher currents. In an upper section, a distribution or feed of the current value to the semiconductor interconnections may be accomplished. This may involve a concentration of the design into a specific area that corresponds to a shadow region 120 of the semiconductor component 118 itself.

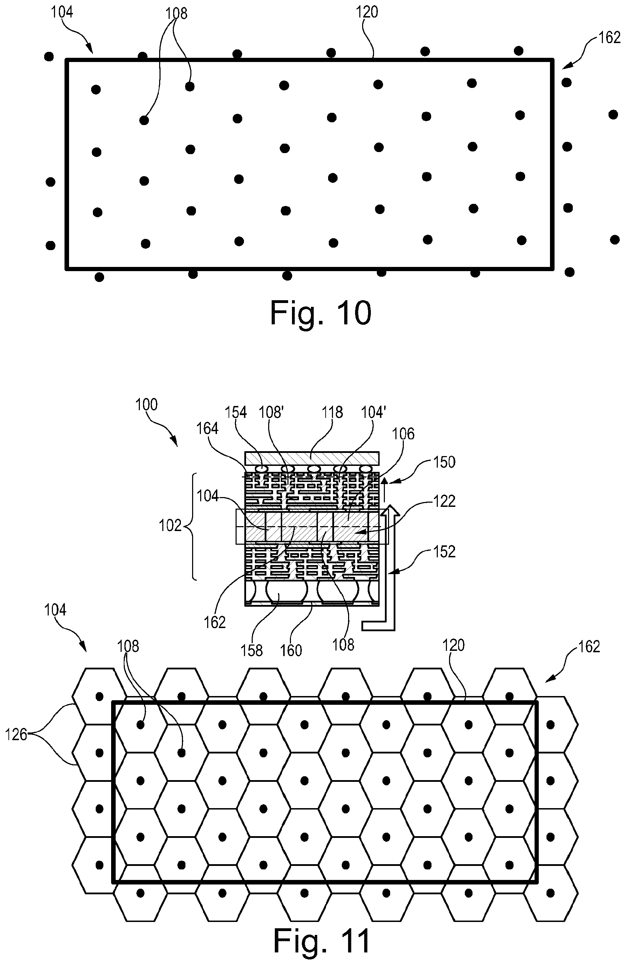

**Figure 10** illustrates a plan view of a wiring plane 162 of a component carrier 100 according to an exemplary embodiment of the invention.

In the embodiment of Figure 10, a shadow region 120 of a surface mounted component 118 is plotted. In such a shadow region 120, such as a projection of the outline of the surface mounted electronic component 118 into the stack 102, an appropriate wiring distribution may be of particular relevance, since such a surface mounted component 118 may have a high number of I/O pads with an electric functionality which has to be guided vertically through the stack 102. Hence, when a component 118 is surface mounted on the stack 102, wiring elements 108 with the above-mentioned pattern may be arranged in shadow area 120 of the surface mounted component 118. Although not shown in Figure 10, the shadow area 120 may taper from an interior of the stack 102 towards the surface mounted component 118.

Within the mentioned shadow area 120, a power voltage and an electric ground potential may be provided. Hence, it may be possible to approach a power feeding from an optimized geometrical computation of the distribution and the configuration of the wiring elements 108.

The distribution of the power features required by predefined values of the transfer of current may be done analytically. Then, the area of interest in terms of power feeding may be used to place the structures following the concept of tessellation, for instance creating areas of competence for each power structure. The concept of applying the creation of Voronoi cells with the positioning of the power feeding mechanically drilled through holes as a seed of each Voronoi cells is shown in Figure 11:

**Figure 11** illustrates a cross-sectional view of a component carrier 100 and a plan view of a wiring plane 162 of the component carrier 100 according to an exemplary embodiment of the invention.

The selection of the honeycomb structure of Figure 11 for defining hexagonal virtual cells 126 may be made to identify an equalized structure for the intermediate layers in the core construction to achieve a uniform contribution of power delivery to a determined closer point to the point of loads represented by the power connection of the surface mounted component 118. The core construction may have at least one additional layer (for example made with a prepreg) that may be used for a finer distribution of starting vertical structures of (for example stacked) laser vias.

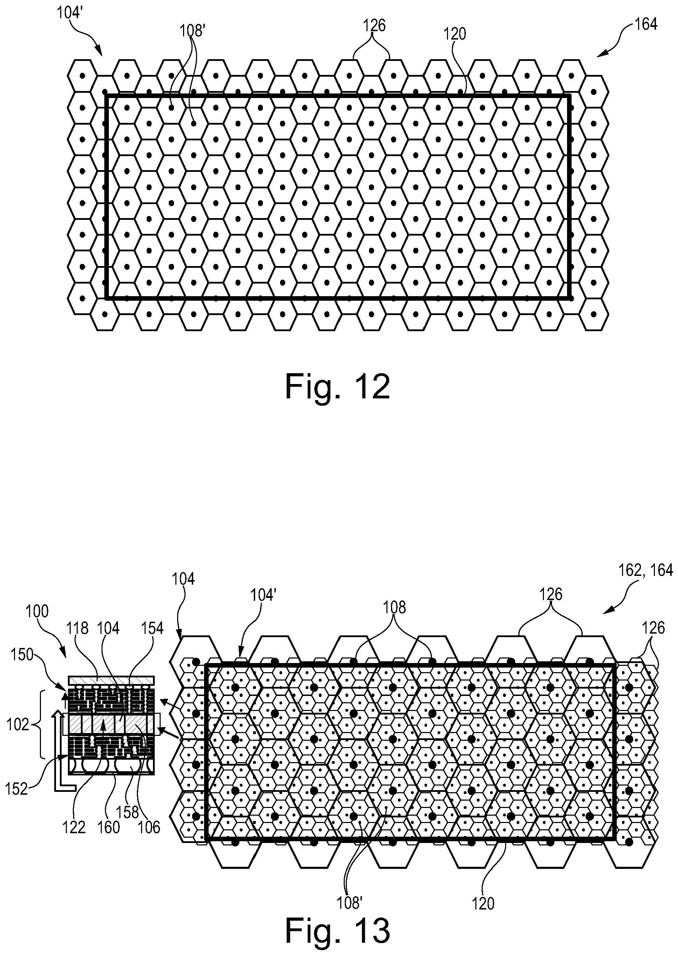

**Figure 12** illustrates a plan view of another wiring plane 164 of the component carrier 100 according to Figure 11. The other wiring plane 164 corresponds to upper build-up 150 and has a higher integration density than core 122. More specifically, a number of wiring elements 108' per area or volume may be higher in the upper build-up 150 than in the core 122. This may lead to a smaller dimension of the hexagonal virtual cells 126 in the upper build-up 150 than in the core 122.

As can be taken from Figure 11 and Figure 12, the honeycomb tessellation is scalable based on the available minimum geometries of the power feeding structures. While it is constructed into a section of the core 122 according to Figure 11, it can be applied as well (even partially) in the above layers in the build-up 150 according to Figure 12 with much smaller (scaled) dimensions.

**Figure 13** illustrates a plan view of an overlay of the wiring planes 162, 164 of Figure 11 and Figure 12.

The dimensioning operation to size the Voronoi cells may be driven by the functional requirement of the specific structures of a component carrier to be designed. In case of mechanically drilled through holes there may be limitations imposed by construction factors of the core, for example the overall total aspect ratio between hole or drill diameter and depth of the holes (thickness of the drilled core). The technology implementation may be governed by the physical limitation of the required steps to achieve the desired result. In the case of the mechanically drilled through holes, it can be the overall resulting aspect ratio limiting the capability of plating the interior part of the vertical holes creating a conductive deposition of copper on the wall of the hole. These limitations may be summarized in design rules to be used in the design of the structures. Examples are the minimum distance between holes (land to land) or the minimum hole diameter or minimum drill diameter compatible with the overall thickness of the core. These geometries may determine other geometrical dimensions that are for example the maximum density (pitch) of the structures. The maximum possible density may determine the maximum contribution of these structures based on the individual capability of a single structure.

Referring again to Figure 12, further electrically conductive layer structure 104' of the stack 102 comprises a plurality of further wiring elements 108' which are arranged in further plane 164 parallel to the wiring plane 162 and which have a corresponding pattern as but another density of wiring elements than the electrically conductive layer structure 104 with the first row 110 and the second row 112 of wiring elements 108, as shown in Figure 11. Wiring plane 162 corresponds to a cross-section through core 122, whereas wiring plane 164 corresponds to a cross-section through the upper build-up 150. Figure 11 and Figure 12 illustrate a tessellation of the die shadow area 120. It may be possible to create areas of influence for each power domain. Figure 11 and Figure 12 illustrate that different wiring planes 162, 164 may be subdivided into hexagonal virtual cells 126 (or Voronoi cells with other geometry) with different cell dimensions. The dimensions of the hexagonal virtual cells 126 in the different wiring planes 162, 164 may reflect different integration densities (for example different numbers of wiring elements 108 per area or volume) in different wiring planes 162, 164. In the shown embodiment, wiring plane 162 has a smaller integration density than wiring plane 164.

This may be a result of a redistribution layer or structure in an interior of the stack 102.

Thus, Figure 11 and Figure 12 show that the described tessellation is scalable. Hence, the described technique may be adapted to specific power delivery targets and the available space.

Still referring to Figure 11 and Figure 12, two different wiring planes 162 (Figure 11) and 164 (Figure 12) are illustrated. Wiring plane 162 of Figure 11 relates to core 122 with a relatively low number of wiring elements 108 per area. In contrast to this, Figure 12 corresponds to a layer of a respective build-up 150 (or 152) which comprises a higher number of wiring elements 108' (or 108") per area or volume. According to a preferred embodiment, the arrangement of the wiring elements 108, 108' in combination with lands (see Figure 12) may be adjusted so that the wiring planes 162 and 164 can be properly electrically interconnected.

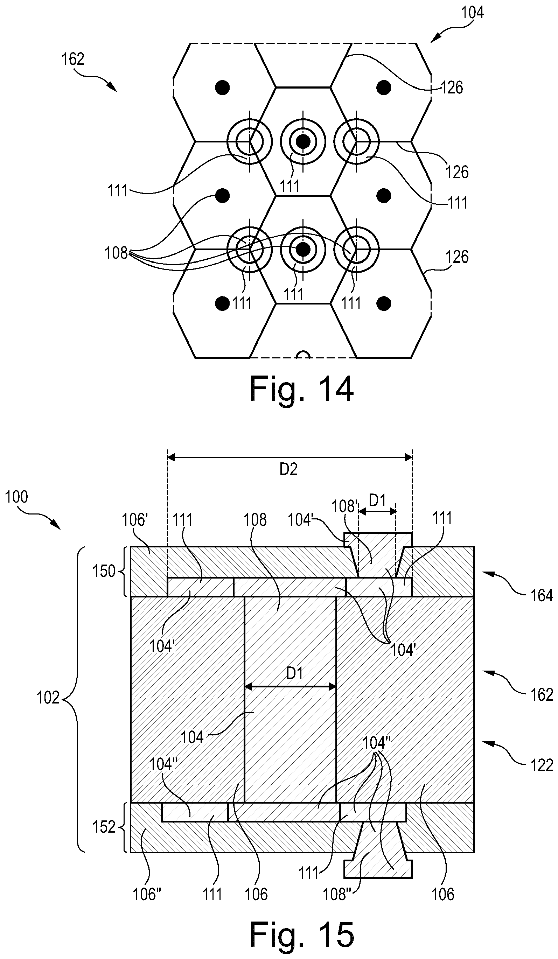

**Figure 14** illustrates a plan view of part of a wiring plane 162 of a component carrier 100 according to an exemplary embodiment of the invention. In principle, Figure 14 shows a larger portion of the wiring plane 162 of Figure 6.

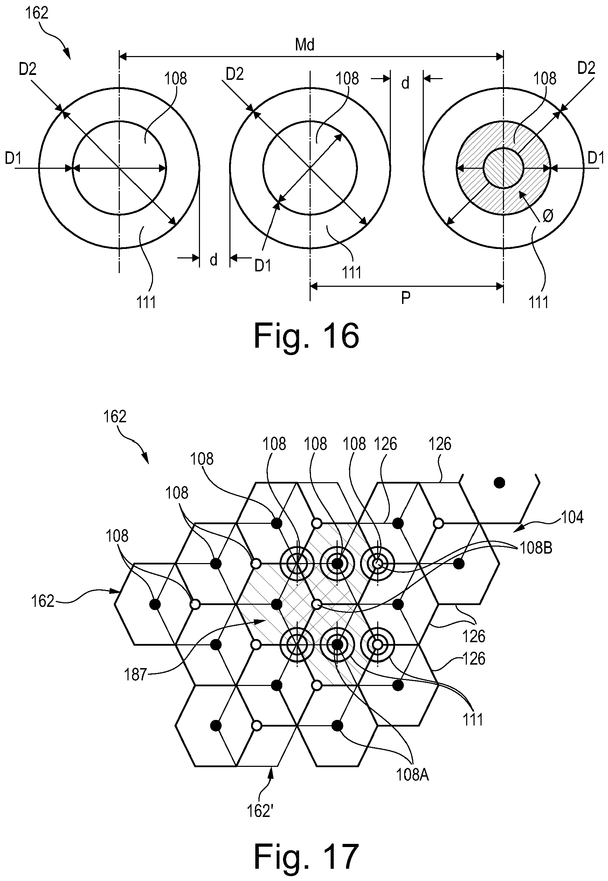

**Figure 15** illustrates a cross-sectional view of part of a component carrier 100 according to an exemplary embodiment of the invention. **Figure 16** illustrates a plan view of part of a wiring plane 162 of the component carrier 100 according to an exemplary embodiment of the invention. The embodiment of Figure 15 differs from the embodiment of Figure 5 in particular in that, according to Figure 15, each of the conductive areas 111 is connected to only a single assigned further wiring element 108' or 108".

To obtain a high degree of freedom of design, and to pursue a large level of Amperes delivered, differential hole or drill diameter structures are possible. Figure 16 illustrates some possible combinations where reference (in particular ground) structures, which may be more redundant than the power feeding structures, may be kept at a smaller diameter while making the power ones larger in diameter. Consequently, a larger conductor cross section may be obtained with a marginal increment of the pitch. The latter allows to maintain, or to reach, a desired level of density within the design.

**Figure 17** illustrates a plan view of different wiring planes 162, 162' of a component carrier 100 according to an exemplary embodiment of the invention.

Figure 17 shows an area of influence 187. Moreover, Figure 17 illustrates different kinds of wiring elements 108 in different wiring planes 162, 162', i.e. wiring elements of first type 108A in wiring plane 162 and wiring elements of second type 108B in wiring plane 162'. In the shown example, the wiring elements of first type 108A may be configured to provide a ground potential, whereas the wiring elements of second type 108B may be configured to provide a power voltage. Every point in the space is served by the wiring elements of second type 108B corresponding to the power domains. More specifically, every power providing wiring element of second type 108B is served by three redundant wiring elements of first type 108A providing an electric reference or ground potential (with possible smaller hole or drill diameters).

More generally, a determination method according to an exemplary embodiment of the invention may link one wiring element of one wiring plane to a plurality of wiring elements of the adjacent next wiring plane.

Figure 17 highlights a portion of the wiring planes 162, 162' which is denoted by reference sign 187. Such a sub-portion may be subject to optimization, fitting or adaptation.

In a dual matrix, it may not be necessary to fill all vertexes. Some may remain available to be used if requirements will impose that. On the other hand, a strategic tessellation can be also used to partition the distribution according to the mapping of the power domains. An empty vertex may provide locations for further power domains.

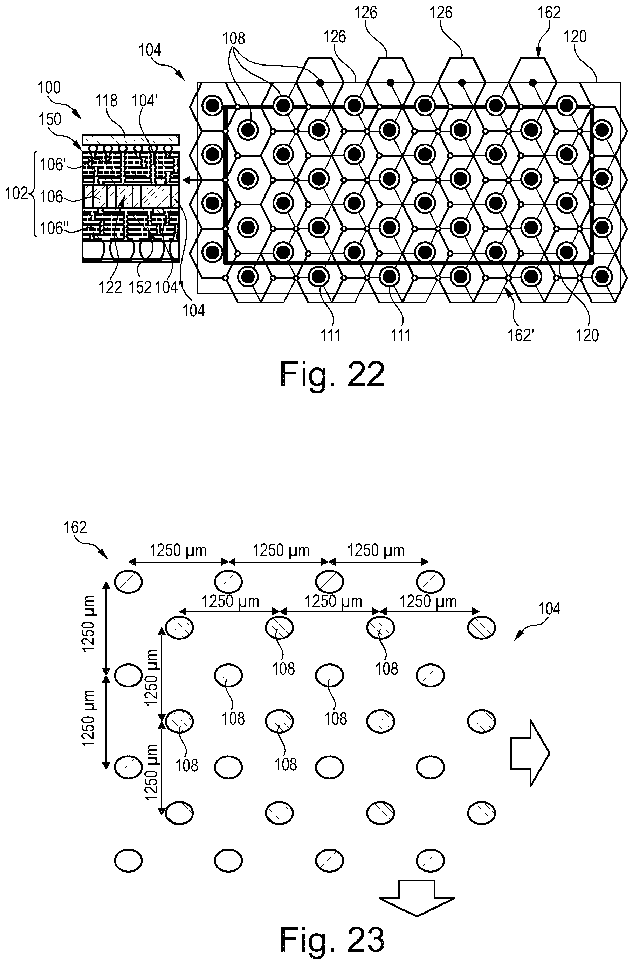

The area of influence 187 is advantageous in terms of placing and/or defining the origin of the construction of the tessellation. It also defines geometrically the potential areas for enlarging the landing zones to be used for connecting the laser vias to the mechanical through holes relating to wiring elements 108 of the core 122 with the laser vias placed into a prepreg layer of the core 122 (the equalization layer). An enlargement of the landing areas is shown in Figure 22.

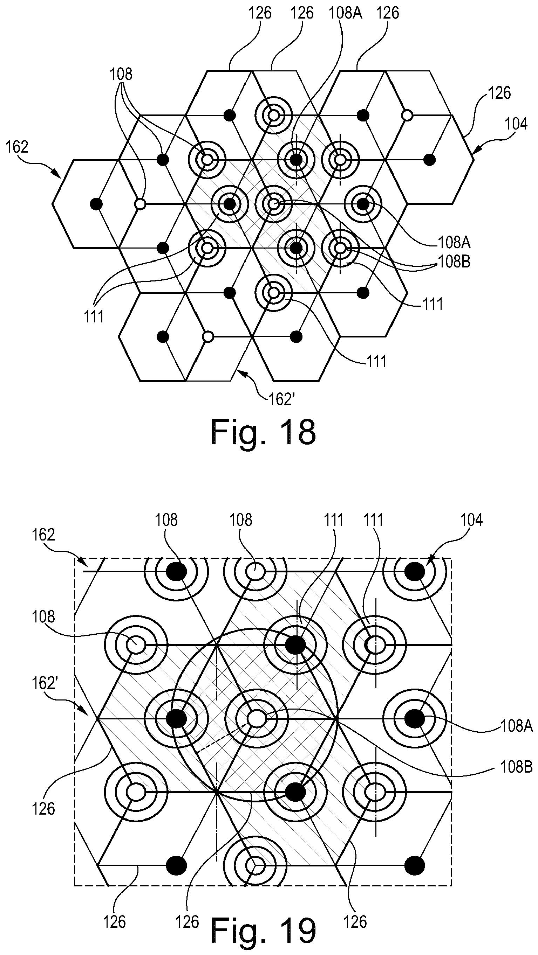

**Figure 18** illustrates a similar view as Figure 17 indicating additional conductive areas 111 around wiring elements 108. **Figure 19** illustrates a detail of Figure 18.

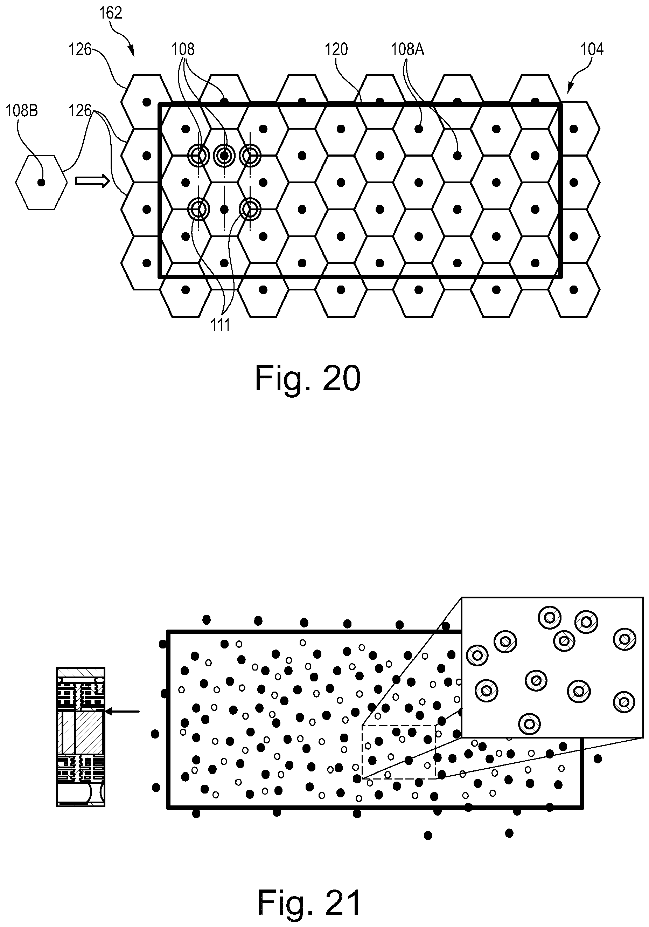

**Figure 20** illustrates a plan view of a wiring plane 162 of a component carrier 100 according to an exemplary embodiment of the invention, to which an additional wiring element of second type 108B is added. Again, tessellation of a die shadow area 120 is illustrated in Figure 20. In particular, Figure 20 shows how to create areas of influence for each power domain. As shown, an additional wiring element of second type 108B is added to the power distribution for wiring elements of first type 108A.

Figure 20 illustrates again that also the lands or conductive areas 111 connected to the respective wiring elements 108 may be taken into account for the design of the component carrier 100.

**Figure 21** illustrates a plan view of a conventional wiring plane of a component carrier.

Figure 21 involves power voltage and ground laser landing areas. For example, areas around wiring elements are available for laser vias landing.

Positions (pitch and rules) of mechanically drilled through holes may address placement of laser vias over the annular ring of the mechanically drilled through holes. Consequently, the position of structures may reach the related semiconductors.

If one or more shadow areas of the one or more semiconductor components is/are projected in the core, this area in the core can be used to facilitate the distribution of the feeding current through some design practices:

a) Partitioning of the area into a uniform pattern of mechanically drilled through holes.

b) The decoupling of the positioning of the power laser vias in the build-up layers in respect of the positioning of the mechanically drilled through holes used for power supply in the core. This may be accomplished by the addition of a prepreg layer in the core construction, allowing where possible a direct feeding through vertical stack of vias.

c) Using a different drilling diameter for mechanically drilled through holes used for power supply compared to others like those for transport of signals and provision of a ground potential.

d) Allowing enough redundancy to protect the power network circuit from current transients through the use of thick copper layers into the core construction and redundant parallelization of the vertical structures.

e) Use of build-up layers assigned to power supply and provision of ground potential to a hybrid configuration to assist the final delivery design.

Partitioning of the shadow area may be performed on a selected (and selectable) grid of coordinates of centers of mechanically drilled through holes.

These may be sizeable based on the level of the targeted current density per desired unit of surface (for example square millimeter).

Figure 21 illustrates a conventional approach that places structures opportunistically and not with a precise pre-ordinated plan, resulting in a random placement without a precise relation between the quantity of the inbound structures currents and outbound structures carrying currents. The enlargement of Figure 21 illustrates the limited areas for landing laser vias onto the top surface of capped mechanical through holes, when an equalizer layer is missing in the construction of the core.

Contrary to the conventional approach of Figure 21, the below described embodiment of the invention according to Figure 22 makes it possible that the areas for landing the power laser vias are greatly extended and normalized by an equalizer layer that helps in the placement of the laser vias stacks reaching vertically the semiconductor's bump pads (see reference sign 154 in Figure 1).

**Figure 22** illustrates a plan view of different wiring planes 162, 162' of a component carrier 100 according to an exemplary embodiment of the invention.

According to Figure 22, power voltage supply and provision of a reference potential (such as ground potential) may be accomplished by a tessellation overlay of wiring elements 108 in different wiring planes 162, 162'. In the illustrated distribution scheme, power laser vias on top/bottom prepregs can be placed in any of the illustrated solid areas to align with build-up stacked vias.

Figure 22 illustrates available areas for landing laser vias within the prepregs, which have a much higher possibility of being aligned to the required vertical stack of laser vias constructed in the build-up layers to reach the semiconductor bumps directly with an optimized structure with the best possible ampacity.

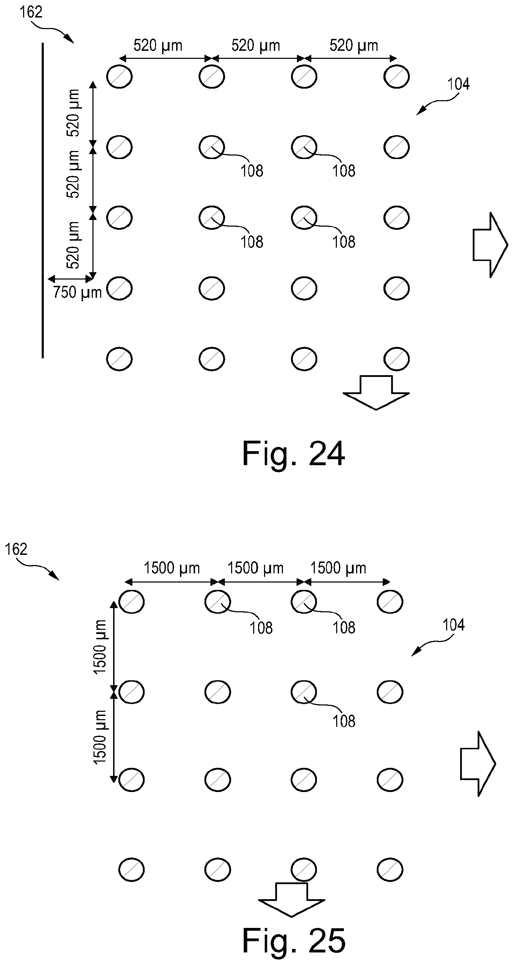

**Figure 23, Figure 24,** and **Figure 25** each illustrate a plan view of a respective wiring plane 162 of a component carrier 100 according to an exemplary embodiment of the invention. In all three embodiments, matrix-like arrangements of wiring elements 108 are displayed addressing different level of density of current or signal transfer across the stack of layers according to the defined product specification and interface interconnection mapping.

**Figure 26** illustrates a plan view of different wiring planes 162, 162' of a component carrier 100 according to an exemplary embodiment of the invention. Figure 26 illustrates that a method of distributing wiring elements 108 may comprise arranging the wiring elements 108 in accordance with hexagonal Voronoi cells 126 around respective wiring elements 108 and by combining sets of wiring elements 108 of neighbouring hexagonal Voronoi cells 126 to four-sided blocks 124. The latter may be parallelogram-type blocks. The arrangement of Figure 26 is compliant with an ampacity target of 10 A/mm$^2$. Figure 26 shows a coverage in the die shadow area 120.

Every point in the space may be served by the power domains. Six hexagons (for example of 447 $\mu$m side length) are shown with their mechanically drilled through holes (for instance of 225 $\mu$m drill or hole diameter), and are filled with electrically conductive material. Copper paste can carry about 10 A in areas of 1.192 mm$^2$ and a temperature difference of 10° C. Current density is shown through a different geometrical space tessellation per 1 mm$^2$ unit of surface.

**Figure 27** illustrates a plan view of a wiring plane 162 of a component carrier 100 according to an exemplary embodiment of the invention. Figure 27 shows that the different wiring elements 108 in centers, in corners or elsewhere in relation to the hexagonal virtual cells 126 may also have different sizes. A cross-sectional area of a wiring element 108 may have an impact on, for example, its current carrying capability.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

## Claims

1. A method of defining a distribution of wiring elements (108) in accordance with at least one target current-related value concerning an electric current to be transmitted over at least a portion of a region between a first main surface and a second main surface of a component carrier (100), wherein the component carrier (100) comprises a stack (102) comprising at least one electrically conductive layer structure (104) and at least one electrically insulating layer structure (106), wherein the at least one electrically insulating layer structure (106) comprises a plurality of wiring elements (108) arranged in a wiring plane (162) to form a first row (110) of equidistant wiring elements (108) arranged along a straight direction within the wiring plane (162) and a second row (112) of equidistant wiring elements (108) arranged along the straight direction within the wiring plane (162), the method comprising:

   defining structural and electrical features of the wiring elements (108);
   defining distribution features indicative of a distribution of the wiring elements (108);
   defining amounts of the distributed wiring elements (108) to be provided in a respective area of the wiring plane (162); and
   defining the distribution of the wiring elements (108) in accordance with requirements of the at least one target current-related value in dependence of the defined structural and electrical features of the wiring elements (108), the defined distribution features, and the defined amounts of the distributed wiring elements (108).

2. The method according to claim 1, wherein defining the distribution features comprises arranging the wiring elements (108) of the second row (112) with an offset along the straight direction with respect to the wiring elements (108) of the first row (110).

3. The method according to claim 1 or 2, wherein defining the distribution features comprises arranging at least part of the wiring elements (108) at centers of hexagonal virtual cells (126) of the wiring plane (162), each of said hexagonal virtual cells (126) being adjacent one to the other sharing a respective side of a respective hexagon with a respective adjacent hexagon.

4. The method according to any of claims 1 to 3, wherein defining the distribution features comprises arranging the wiring elements (108) so that a mutual distance (b) between adjacent equidistant wiring elements (108) of the first row (110) equals to a mutual distance (b) between adjacent equidistant wiring elements (108) of the second row (112).

5. The method according to any of claims 1 to 4, wherein the method comprises providing a plurality of further wiring elements (108') in a further electrically insulating layer structure (106') of the stack (102), and arranging the plurality of further wiring elements (108') in a further wiring plane (164) parallel to the wiring plane (162) and in accordance with a corresponding pattern as but another density of wiring elements than the first row (110) and the second row (112) of wiring elements (108).

6. The method according to any of claims 1 to 5, wherein the method comprises arranging the at least one electrically insulating layer structure (106) comprising the wiring elements (108) in a core (122) of the component carrier (100).

7. The method according to any of claims 1 to 6, wherein the at least one target current-related value comprises a minimum requirement relating to a target current carrying capability, in particular a current density of 0.5 A/mm$^2$ to 15 A/mm$^2$.

8. The method according to any of claims 1 to 7, wherein the structural and electrical features comprise at least one of a hole diameter (D1) of the wiring elements (108), a cross sectional area of the wiring elements (108), at least one wall plating-related parameter of the wiring elements (108), at least one operation temperature-related property of the wiring elements (108), a dimension of a conductive area (111) directly connected with the wiring elements (108), in particular a land diameter (D2) of the wiring elements (108), a current carrying capability of the wiring elements (108), and a resistivity of the wiring elements (108).

9. The method according to any of claims 1 to 8, wherein the distribution features are indicative of a pattern, in particular of a regular pattern and/or of a Voronoi pattern, in accordance with which the wiring elements (108) are to be arranged.

10. The method according to any of claims 1 to 9, wherein the distribution features comprise at least one of at least one equidistance parameter (b), in particular depending on a hole diameter (D1) and/or a land diameter (D2) of the wiring elements (108), an offset value (f) indicating an offset between the wiring elements (108) of the first row (110) and of the second row (112) with respect to each other, and at least one parameter indicating an overlap of wiring elements (108) of different areas.

11. The method according to any of claims 1 to 10, wherein the method comprises defining the amounts of the distributed wiring elements (108) depending on the structural and electrical features and/or depending on the distribution features.

12. The method according to any of claims 1 to 11, wherein the method comprises defining the distribution of the wiring elements (108) in accordance with said requirements by a processor (113), wherein in particular the method comprises defining the distribution by the processor (113) executing a fitting algorithm fitting one or more variable design parameters different from the defined requirements.

13. The method according to any of claims 1 to 12, wherein the method comprises defining the distribution of the wiring elements (108) in accordance with said requirements using an artificial intelligence module (115).

14. The method according to any of claims 1 to 13, wherein the method comprises manufacturing the component carrier (100) in accordance with the defined distribution of wiring elements (108).

15. A component carrier (100), comprising:

a stack (102) comprising at least one electrically conductive layer structure (104) and at least one electrically insulating layer structure (106); a plurality of wiring elements (108) on the at least one electrically insulating layer structure (106) which are arranged in a wiring plane (162) to form a first row (110) of equidistant wiring elements (108) arranged along a straight direction within the wiring plane (162) and a second row (112) of equidistant wiring elements (108) arranged along the straight direction within the wiring plane (162); wherein said wiring elements (108) are distributed within the wiring plane (162) to comply with a target current-related value concerning an electric current to be transmitted over at least a portion of a region between a first main surface and a second main surface of the component carrier (100), said at least one target current-related value corresponding to a ratio between an area value occupied by electrically conductive material of the wiring elements (108) within a unit area and an area value of the unit area of the stack (102), from a frontal view, in a range from 6% to 11%.

Fig. 1

Fig. 2

Fig. 3

Fig. 4

Fig. 5

Fig. 6

# Fig. 7

EP 4 372 812 A1

| At 10°C ΔT | Wall Plating um | | | At 10°C ΔT | Filled Cu plated | | | Amp ratio Filled vs plating | | | Cu Area at 25 um mm^2 | Cu Area filled mm^2 | Area ratio | At 15° C Δ Filled Cu plated | | |
|---|---|---|---|---|---|---|---|---|---|---|---|---|---|---|---|---|
| Drill (um) | 15 | 20 | 25 | Drill (um) | Amps | Land | Space | 15 | 20 | 25 | | | | Drill | Amps | Land |
| 150 | 0,757 | 0,859 | 0,9444 | 150 | 1,32406 | 300 | 50 | 75% | 54% | 40% | 0,009817 | 0,017671 | 80% | 150 | 1,62164 | 300 / 50 |
| 200 | 0,90443 | 1,03151 | 1,13878 | 200 | 1,80392 | 350 | 50 | 99% | 75% | 58% | 0,013744 | 0,031416 | 129% | 200 | 2,20934 | 350 / 50 |
| 225 | 0,97174 | 1,10991 | 1,2272 | 225 | 2,04741 | 375 | 50 | 111% | 84% | 67% | 0,015708 | 0,039761 | 153% | 225 | 2,50756 | 375 / 50 |
| 250 | 1,03577 | 1,18441 | 1,31115 | 250 | 2,29295 | 400 | 50 | 121% | 94% | 75% | 0,017671 | 0,049087 | 178% | 250 | 2,80828 | 400 / 50 |
| 275 | 1,097 | 1,2556 | 1,39129 | 275 | 2,54034 | 425 | 50 | 132% | 102% | 83% | 0,019635 | 0,059396 | 203% | 275 | 3,11127 | 425 / 50 |
| 300 | 1,1558 | 1,32392 | 1,46816 | 300 | 2,78943 | 450 | 50 | 141% | 111% | 90% | 0,021598 | 0,070686 | 227% | 300 | 3,41634 | 450 / 50 |
| 350 | 1,26725 | 1,45331 | 1,61363 | 350 | 3,29217 | 500 | 50 | 160% | 127% | 104% | 0,025525 | 0,096211 | 277% | 350 | 4,03207 | 500 / 50 |
| 400 | 1,37187 | 1,57468 | 1,74998 | 400 | 3,80035 | 600 | 50 | 177% | 141% | 117% | 0,029452 | 0,25664 | 327% | 400 | 4,65447 | 600 / 50 |

| Laser via | Electrical Diameter | Pitch | Area mm^2 per Via | Tot/mm^2 | Amp.Tot. Max. | At 10°C ΔT | max A inbound | Assigned LaserVias to Vcc | Inbound Target Amperes | |
|---|---|---|---|---|---|---|---|---|---|---|
| Diam | 30 | 0,078 | 0,00478 | 209 | 39,29 | | 19,65 | 54 | 10,152 | |
| Diam | 25 | 0,073 | 0,00419 | 238 | 36,75 | | 18,37 | 68 | 10,4992 | |
| | | | | | | | | | Same Qty to Vss needed | |

Used area by a land of x um diameter — Ampacity in Effective power assignment 1/2 Vcc 1/2 Vss

| Land Diameter mm | Pitch Diameter | Area mm^2 | Qty mm^2 Q.ty | Amp.Tot. 15um Amps | Amp.Tot. 20um Amps | Amp.Tot. 25um Amps | 15um Amps | 20um Amps | 25um Amps | Drill | Land Diameter mm | Pitch Diameter | Area mm^2 | Qty mm^2 Q.ty | 10 Deg C Filled Amps | 15 Deg C Filled Amps | 6 MTHs |
|---|---|---|---|---|---|---|---|---|---|---|---|---|---|---|---|---|---|
| 0,3 | 0,35 | 0,096 | 10 | 7,57 | 8,59 | 9,44 | 3,79 | 4,30 | 4,72 | 150 | 0,3 | 0,35 | 0,096 | 10 | 13,24 | 16,22 | |
| 0,35 | 0,4 | 0,126 | 7 | 6,33 | 7,22 | 7,97 | 3,17 | 3,61 | 3,99 | 200 | 0,35 | 0,4 | 0,126 | 7 | 12,63 | 15,47 | |
| 0,375 | 0,425 | 0,142 | 7 | 6,80 | 7,77 | 8,59 | 3,40 | 3,88 | 4,30 | 225 | 0,375 | 0,425 | 0,142 | 7 | 14,33 | 17,55 | 15,05 |
| 0,4 | 0,45 | 0,159 | 6 | 6,21 | 7,11 | 7,87 | 3,11 | 3,55 | 3,93 | 250 | 0,4 | 0,45 | 0,159 | 6 | 13,76 | 16,85 | |
| 0,425 | 0,475 | 0,177 | 5 | 5,49 | 6,28 | 6,96 | 2,74 | 3,14 | 3,48 | 275 | 0,425 | 0,475 | 0,177 | 5 | 12,70 | 15,56 | |
| 0,5 | 0,5 | 0,196 | 5 | 5,78 | 6,62 | 7,34 | 2,89 | 3,31 | 3,67 | 300 | 0,45 | 0,5 | 0,196 | 5 | 13,95 | 17,08 | |
| 0,45 | 0,55 | 0,238 | 4 | 5,07 | 5,81 | 6,45 | 2,53 | 2,91 | 3,23 | 350 | 0,5 | 0,55 | 0,238 | 4 | 13,17 | 16,13 | |

Fig. 8

Fig. 9

Fig. 10

Fig. 11

Fig. 12

Fig. 13

Fig. 14

Fig. 15

# Fig. 16

# Fig. 17

Fig. 18

Fig. 19

Fig. 20

Fig. 21

Fig. 22

Fig. 23

162

520 µm    520 µm    520 µm

520 µm
520 µm
520 µm
520 µm

750 µm

104

108    108

108    108

## Fig. 24

162

1500 µm    1500 µm    1500 µm

108    108

104

1500 µm

1500 µm

108

## Fig. 25

Fig. 26

Fig. 27

Europäisches Patentamt
European Patent Office
Office européen des brevets

# EUROPEAN SEARCH REPORT

**Application Number**

EP 22 20 7786

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/043051 A1 (LIN YEN-LIANG [TW] ET AL) 11 February 2016 (2016-02-11) | 1,2,4,6, 8-10, 12-15 | INV. H01L23/498 |
| Y | * figures 1,8,10-12,14-16 * | 3 | |
| X | US 6 388 207 B1 (FIGUEROA DAVID G [US] ET AL) 14 May 2002 (2002-05-14) * figures 4,5 * | 1,7,14 | |
| X | US 2012/068322 A1 (HANABE MITSUHIRO [JP]) 22 March 2012 (2012-03-22) * figure 1 * | 1,14 | |
| X | JP 2018 098339 A (CANON KK) 21 June 2018 (2018-06-21) * figure 2 * & US 2018/168039 A1 (NUMAGI TAKASHI [JP] ET AL) 14 June 2018 (2018-06-14) | 1,3,9, 11,14 | |
| X | US 2007/230150 A1 (CASTRIOTTA MICHELE [IT] ET AL) 4 October 2007 (2007-10-04) * figures 1a,b * | 1,5,9,14 | |
| | | | **TECHNICAL FIELDS SEARCHED (IPC)** |
| Y | US 2017/018478 A1 (MAPLE MARSHALL [US] ET AL) 19 January 2017 (2017-01-19) * figures 1A,B * | 3 | H01L |

The present search report has been drawn up for all claims

| Place of search | Date of completion of the search | Examiner |
|---|---|---|
| The Hague | 28 April 2023 | Kästner, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 20 7786

This annex lists the patent family members relating to the patent documents cited in the above-mentioned European search report.
The members are as contained in the European Patent Office EDP file on
The European Patent Office is in no way liable for these particulars which are merely given for the purpose of information.

28-04-2023

| Patent document cited in search report | | Publication date | Patent family member(s) | | Publication date |
|---|---|---|---|---|---|
| US 2016043051 | A1 | 11-02-2016 | CN | 105374779 A | 02-03-2016 |
| | | | KR | 20160018349 A | 17-02-2016 |
| | | | TW | 201606959 A | 16-02-2016 |
| | | | US | 2016043051 A1 | 11-02-2016 |
| | | | US | 2017213804 A1 | 27-07-2017 |
| US 6388207 | B1 | 14-05-2002 | NONE | | |
| US 2012068322 | A1 | 22-03-2012 | CN | 102412209 A | 11-04-2012 |
| | | | JP | 5581933 B2 | 03-09-2014 |
| | | | JP | 2012069618 A | 05-04-2012 |
| | | | KR | 20120031121 A | 30-03-2012 |
| | | | TW | 201214647 A | 01-04-2012 |
| | | | US | 2012068322 A1 | 22-03-2012 |
| JP 2018098339 | A | 21-06-2018 | JP | 6818534 B2 | 20-01-2021 |
| | | | JP | 2018098339 A | 21-06-2018 |
| | | | US | 2018168039 A1 | 14-06-2018 |
| US 2007230150 | A1 | 04-10-2007 | NONE | | |
| US 2017018478 | A1 | 19-01-2017 | NONE | | |

EPO FORM P0459

For more details about this annex : see Official Journal of the European Patent Office, No. 12/82